(19) **Europäisches Patentamt / European Patent Office / Office européen des brevets**

(11) **EP 3 190 672 B1**

(12) **FASCICULE DE BREVET EUROPEEN**

(45) Date de publication et mention
de la délivrance du brevet:
**18.04.2018 Bulletin 2018/16**

(51) Int Cl.:
*H01S 5/02* *(2006.01)*          *H01S 5/10* *(2006.01)*
*H01S 5/14* *(2006.01)*

(21) Numéro de dépôt: **17150156.2**

(22) Date de dépôt: **03.01.2017**

(54) **SOURCE LASER À SEMI-CONDUCTEUR**

LASERQUELLE MIT HALBLEITER

SEMICONDUCTOR LASER SOURCE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **08.01.2016 FR 1650171**

(43) Date de publication de la demande:
**12.07.2017 Bulletin 2017/28**

(73) Titulaire: **Commissariat à l'énergie atomique
et aux énergies alternatives
75015 Paris (FR)**

(72) Inventeur: **MENEZO, Sylvie
38500 VOIRON (FR)**

(74) Mandataire: **Colombo, Michel
Innovation Competence Group
310, avenue Berthelot
69372 Lyon Cedex 08 (FR)**

(56) Documents cités:
**GB-A- 2 522 252          US-A1- 2009 135 861
US-A1- 2014 153 600          US-A1- 2014 153 601
US-A1- 2015 180 201**

• **NOBUHIDE FUJIOKA ET AL: "Compact and Low
Power Consumption Hybrid Integrated
Wavelength Tunable Laser Module Using Silicon
Waveguide Resonators", JOURNAL OF
LIGHTWAVE TECHNOLOGY, IEEE SERVICE
CENTER, NEW YORK, NY, US, vol. 28, no. 21, 1
novembre 2010 (2010-11-01), pages 3115-3120,
XP011339909, ISSN: 0733-8724, DOI:
10.1109/JLT.2010.2073445**

**Description**

L'invention concerne une source laser à semi-conducteur apte à émettre à au moins une longueur d'onde $\lambda_{Li}$, ainsi qu'un procédé de fabrication de cette source laser.

Des sources laser connues des inventeurs comportent :

- un réflecteur avant et un réflecteur arrière, ces réflecteurs avant et arrière formant les extrémités d'une cavité optique Fabry-Pérot apte à faire résonner un signal optique à plusieurs fréquences de résonance possibles, les longueurs d'onde possibles $\lambda_{Rj}$ de ces fréquences de résonance possibles étant régulièrement espacées les unes des autres par un intervalle $\Delta\lambda_R$ et toutes comprises à l'intérieur d'une bande réfléchissante des réflecteurs avant et arrière centrée sur une longueur d'onde $\lambda_{CR}$ et de largeur $\Delta R$,
- un ensemble de guides d'onde raccordant optiquement les réflecteurs avant et arrière entre eux, cet ensemble comportant :

  • un guide d'onde en silicium,
  • un filtre passe-bande réalisé dans un guide d'onde et agencé pour être traversé par le signal optique résonant entre les réflecteurs avant et arrière, ce filtre passe-bande étant apte à sélectionner au moins une longueur d'onde $\lambda_{Li}$ parmi les longueurs d'onde $\lambda_{Rj}$, le filtre passe-bande comportant à cet effet une bande passante centrée sur chaque longueur d'onde $\lambda_{Li}$ à sélectionner, chaque bande passante du filtre étant centrée sur une longueur d'onde centrale $\lambda_{Cf}$ respective et ayant une largeur $\Delta\lambda_f$ de bande inférieure ou égal à l'intervalle $\Delta\lambda_R$,
  • un guide d'onde en matériau à gain III-V apte à générer du gain optique à chaque longueur d'onde $\lambda_{Li}$ sélectionnée par le filtre et agencé pour être traversé par le signal optique résonant entre les réflecteurs avant et arrière, ce guide d'onde étant couplé au guide d'onde en silicium par un couplage adiabatique apte à transformer un mode optique guidé du guide d'onde en silicium en un mode optique guidé du guide d'onde en matériau à gain III-V.

Dans ces sources laser connues des inventeurs, le filtre et les réflecteurs sont réalisés dans des guides d'onde en silicium et le filtre ne sélectionne qu'une unique longueur d'onde.

Lorsque la température de fonctionnement des sources laser connues varie, la longueur d'onde d'émission de ces sources laser varie également à raison d'environ 0.07 nm/°C. À cause de cela, on dit que ces sources laser connues sont sensibles à la température et que la longueur d'onde d'émission de la source laser dérive en fonction de la température.

Pour remédier à cet inconvénient, il est connu d'associer la source laser à un dispositif de régulation de sa température de fonctionnement pour la maintenir à une température constante. Toutefois, de tels dispositifs de régulation sont encombrants et consomment beaucoup d'énergie.

De l'état de la technique est également connu de :

- US2015/180201A1,
- NOBUHIDE FUJIOKA et Al : « Compact and Low Power Consumption Hybrid Integrated Wavelength Tunable Laser Module Using Silicon Waveguide Resonators », Journal of Lightwave Technology, IEEE Service center, US, vol. 28, N°21, 1/11/2010,
- US2014/153600A1,
- US2014/153601A1,
- GB2522252A,
- US2009/135891A1.

L'invention vise à remédier à cet inconvénient en proposant une source laser à semi-conducteur moins sensible aux variations de température tout en restant simple à fabriquer. Elle a donc pour objet une source laser à semi-conducteur conforme à la revendication 1.

Pour limiter la dérive en température de la source laser revendiquée, la solution proposée consiste à réaliser le filtre dans un guide d'onde non plus en silicium mais dans un matériau moins sensible à la température et d'intégrer ce filtre à la structure de la source laser. En effet, le fait que le guide d'onde dans lequel est réalisé le filtre soit dans un matériau dont la variation de l'indice de réfraction en fonction de la température est au moins deux fois moins rapide que la variation de l'indice de réfraction du silicium permet de limiter la dérive en température du filtre. De plus, le dispositif d'accord, le capteur et le circuit électronique permettent de maintenir en permanence une longueur d'onde $\lambda_{Rj}$ au centre de chaque bande passante du filtre qui sélectionne une longueur d'onde $\lambda_{Li}$. Cela a pour conséquence de réduire l'amplitude de la dérive en température de la longueur d'onde d'émission $\lambda_{Li}$ de la source laser sans qu'il soit nécessaire d'avoir recours à un dispositif de régulation de la température de la source laser.

L'intégration dans la source laser de ce filtre est rendue possible par la mise en oeuvre d'une structure de source laser à trois guides d'onde, à savoir un guide d'onde en silicium, un guide d'onde en matériau à gain III-V et un guide d'onde en matériau moins sensible à la température. Cette structure à trois guides d'onde permet notamment de contourner la difficulté selon laquelle il est difficile de réaliser un couplage adiabatique directement entre le guide d'onde en matériau moins sensible à la température et le guide d'onde en matériau à gain III-V. En effet, les matériaux de ces deux guides d'onde présentent généralement de grandes différences d'indice de réfraction optique. Dans la source laser revendiquée, il est donc proposé d'utiliser un guide d'onde en silicium pour coupler, d'une part, le guide d'onde en matériau à gain III-V au guide d'onde en silicium et, d'autre part, le guide d'onde en silicium au guide d'onde en matériau moins sensible à la température. Ainsi, les guides d'onde en matériau à gain III-V et en matériau moins sensible à la température sont couplés l'un à l'autre par l'intermédiaire du guide d'onde en silicium. De plus, la présence du guide d'onde en silicium peut être mise à profit pour fabriquer un dispositif d'accord particulièrement efficace. En effet, la variation de l'indice de réfraction du silicium en fonction de la température est importante et il est aussi possible de générer simplement des porteurs libres dans un guide d'onde en silicium. Ces deux phénomènes modifient la phase du signal optique qui se propage dans le guide d'onde en silicium.

Les modes de réalisation de cette source laser peuvent présenter une ou plusieurs des caractéristiques des revendications dépendantes.

Ces modes de réalisation de la source laser présentent en outre les avantages suivants :

- L'utilisation d'un anneau résonant en tant que filtre permet de limiter l'encombrement du filtre et donc l'encombrement de la source laser à semi-conducteur.
- L'utilisation d'un anneau résonant dont plusieurs bandes passantes sont comprises à l'intérieur de la bande réfléchissante des réflecteurs permet de réaliser simplement une source laser multi-longueurs d'onde. En particulier, un seul et même matériau à gain est utilisé pour les différentes longueurs d'onde d'émission de cette source laser multi-longueurs d'onde.
- L'utilisation d'un anneau résonant permet également de raccorder directement le filtre au guide d'onde en silicium seulement par l'intermédiaire d'un couplage évanescent et sans avoir recours à un couplage adiabatique. Cela permet de diminuer l'encombrement de la source laser en évitant le recours à des coupleurs adiabatiques. En effet, dans ce cas, seul l'anneau résonant est réalisé dans un matériau moins sensible à la température.
- Le fait de fabriquer le filtre d'un côté d'une couche contenant les guides d'onde en silicium et de fabriquer, du côté opposé, le guide d'onde en matériau à gain, simplifie le collage de la couche contenant le matériau à gain sur le silicium. Cela permet également une gravure beaucoup plus précise du filtre.
- Le fait que le dispositif d'accord soit réalisé, au-dessus du guide d'onde silicium, et dans la même sous-couche en matériau dopé que celle qui est utilisée pour former le guide d'onde en matériau à gain simplifie la fabrication du dispositif d'accord. En effet, les opérations de fabrication du dispositif d'accord et du guide d'onde en matériau à gain peuvent alors être simultanément réalisées. De plus ce type d'accord est sans perte pour le mode optique de la cavité, contrairement aux dispositifs d'accord faisant usage de jonctions PN ou PIN réalisées dans le guide d'onde en silicium
- L'utilisation du nitrure de silicium ou du nitrure d'aluminium en tant que matériau moins sensible à la température permet de diviser par au moins cinq la sensibilité de la source laser à la température.
- Le fait de réaliser les réflecteurs au moins en partie dans le matériau moins sensible à la température permet de limiter leur sensibilité à la température. Ceci permet d'utiliser des réflecteurs dont la largeur ΔR de la bande réfléchissante est plus faible.

L'invention a également pour objet un procédé de fabrication de la source laser revendiquée.

L'invention sera mieux comprise à la lecture de la description qui va suivre, donnée uniquement à titre d'exemple non limitatif et faite en se référant aux dessins sur lesquels :

- les figures 1 à 3 sont des représentations schématiques de la position de la bande réfléchissante des réflecteurs d'une source laser à semi-conducteur par rapport à la bande passante du filtre de cette source laser à semi-conducteur ;
- la figure 4 est une illustration schématique de l'architecture d'une source laser à semi-conducteur ;
- la figure 5 est une illustration schématique en vue de dessus d'un exemple de filtre en anneau résonant pouvant être mis en oeuvre dans la source laser de la figure 4;
- la figure 6 est un graphe illustrant schématiquement la position de la bande réfléchissante des réflecteurs par rapport à la bande passante du filtre de la figure 5 ;
- la figure 7 est une illustration schématique, en coupe verticale, du filtre de la figure 5 dans le cas où le couplage du guide d'onde en silicium vers le guide d'onde en nitrure de silicium se fait par couplage évanescent;
- la figure 8 est une illustration schématique, en coupe verticale, d'un premier mode de réalisation de la source laser de la figure 4 ;

- la figure 9 est un organigramme d'un procédé de fabrication de la source laser de la figure 8 ;
- les figures 10 à 14 sont des illustrations schématiques, en coupe verticale, de différents stades de fabrication de la source laser de la figure 8 ;
- la figure 15 est un organigramme d'un autre procédé de fabrication d'une source laser à semi-conducteur ;
- les figures 16 à 18 sont des illustrations schématiques, en coupe verticale, de différents stades de fabrication d'une source laser à semi-conducteur selon le procédé de la figure 15 ;
- les figures 19 à 21 sont des illustrations schématiques, en coupe verticale, de différentes variantes de réalisation d'une source laser à semi-conducteur ;
- la figure 22 est une illustration schématique de différents éléments d'une source laser multi-longueurs d'onde ;
- la figure 23 est un graphe illustrant schématiquement la position de la bande réfléchissante des réflecteurs de la source laser de la figure 22 par rapport aux bandes passantes d'un filtre de cette source laser ;
- la figure 24 est une illustration schématique, en coupe verticale, d'un mode de réalisation particulier d'un dispositif d'accord utilisable dans une source laser ;
- la figure 25 est une illustration schématique, en vue de dessus, du dispositif d'accord de la figure 24 ;
- la figure 26 est une illustration schématique, en vue de dessus, d'un autre mode de réalisation d'un filtre pour la source laser de la figure 4.

Dans ces figures, les mêmes références sont utilisées pour désigner les mêmes éléments. Dans la suite de cette description, les caractéristiques et fonctions bien connues de l'homme du métier ne sont pas décrites en détail.

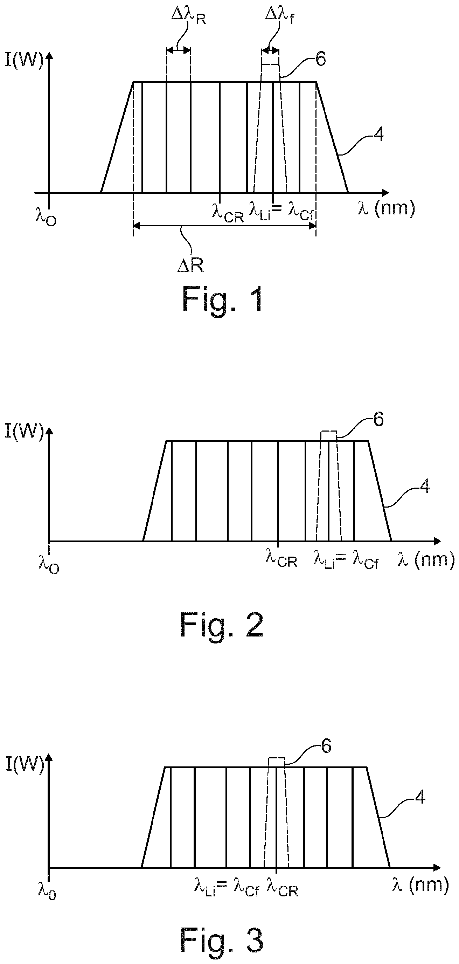

La raison pour laquelle la réalisation du filtre dans un guide d'onde en matériau moins sensible à la température diminue la sensibilité de la source laser à la température va d'abord être expliquée en détail en référence aux figures 1 à 3. Ensuite, l'architecture générale d'une source laser à semi-conducteur utilisant un tel filtre est décrite suivie de plusieurs exemples particuliers de réalisation.

La figure 1 représente une bande réfléchissante 4 des réflecteurs avant et arrière d'une cavité optique de Fabry-Pérot d'une source laser à semi-conducteur connue. Cette bande passante 4 est représentée sur un graphe où l'axe des abscisses représente la longueur d'onde et est exprimé en nanomètre et l'axe des ordonnées correspond à la puissance du signal optique exprimée en Watt.

La bande réfléchissante 4 est caractérisée par sa largeur $\Delta R$ et sa longueur d'onde centrale $\lambda_{CR}$. La largeur $\Delta R$ est la largeur de la bande réfléchissante 4 à -3 dB. Il s'agit de la bande de longueurs d'onde contenant toutes les longueurs d'onde $\lambda_{Rj}$ aptes à être réfléchies par les réflecteurs avant et arrières avec une puissance supérieure ou égale à 50 % de la puissance maximale $I_{max}$ réfléchie par ces réflecteurs. La puissance $I_{max}$ est égale à la puissance du signal optique réfléchi pour la longueur d'onde $\lambda_{Rj}$ pour laquelle cette puissance est maximale.

La longueur d'onde centrale $\lambda_{CR}$ est la longueur d'onde située au milieu de la bande réfléchissante 4.

Dans le contexte d'une cavité de Fabry-Pérot, les différentes longueurs d'onde $\lambda_{Rj}$ auxquelles cette cavité est susceptible de résonner sont régulièrement espacées les unes des autres par un intervalle $\Delta\lambda_R$. Sur la figure 1, les longueurs d'onde $\lambda_{Rj}$ auxquelles la cavité de Fabry-Pérot peut résonner et qui sont situées à l'intérieur de la bande passante 4 sont représentées par des traits verticaux.

Dans le cadre d'une source laser monochromatique qui émet à une seule longueur d'onde $\lambda_{Li}$, le filtre sélectionne parmi l'ensemble des longueurs d'onde $\lambda_{Rj}$ possibles une seule de ces longueurs $\lambda_{Rj}$. La longueur d'onde $\lambda_{Rj}$ sélectionnée est égale à la longueur d'onde $\lambda_{Li}$ d'émission de la source laser. À cet effet, le filtre présente une seule bande passante 6 étroite centrée sur la longueur d'onde $\lambda_{Li}$. Cette bande passante 6 est caractérisée par sa largeur $\Delta\lambda_f$ et par sa longueur d'onde centrale $\lambda_{Cf}$. La largeur $\Delta\lambda_f$ est la largeur de la bande passante 6 à -3 dB. La longueur d'onde centrale $\lambda_{Cf}$ est la longueur d'onde située au milieu de la bande passante 6. Pour sélectionner la seule longueur d'onde $\lambda_{Li}$, la largeur $\Delta\lambda_f$ est inférieure ou égale à l'intervalle $\Delta\lambda_R$. Pour sélectionner la longueur d'onde $\lambda_{Li}$, l'une des longueurs d'onde $\lambda_{Rj}$, typiquement la plus proche de $\lambda_{Cf}$, est accordée pour être égale à cette longueur d'onde $\lambda_{Cf}$. Cette longueur d'onde $\lambda_{Rj}$ qui est égale à la longueur d'onde $\lambda_{Cf}$ correspond à la longueur d'onde $\lambda_{Li}$.

Le graphe de la figure 1 est représenté pour une température de fonctionnement de la source laser égale à 20 °C.

Dans les sources laser connues, le signal optique est guidé entre les réflecteurs avant et arrière par des guides d'onde en silicium et en matériaux à gain III-V. Les réflecteurs et le filtre sont réalisés dans les guides d'onde en silicium, et la fonction de gain est réalisée dans le guide d'onde en matériaux III-V. Dans ces conditions, il est connu que les longueurs d'onde $\lambda_{Rj}$ et la longueur d'onde $\lambda_{CR}$ se déplacent en fonction de la température d'environ 0,07 nm/°C. La longueur d'onde $\lambda_{Cf}$ se déplace elle aussi d'environ 0,07 nm/°C.

Le graphe de la figure 2 représente les mêmes éléments que le graphe de la figure 1, mais pour une température de fonctionnement de la source laser égale à 33°C. On peut constater que la bande passante 4 et les longueurs d'onde $\lambda_{CR}$ et $\lambda_{Rj}$ se sont déplacées de d'environ 0.9 nm (environ 0.07 x 13°C) et que la bande passante 6 s'est déplacée de d'environ 0.9 nm. La longueur d'onde $\lambda_{Li}$ de la source laser s'est donc déplacée d'environ 0.9 nm.

Pour limiter cette dérive de la longueur d'onde $\lambda_{Li}$, la solution proposée consiste à réaliser le filtre dans un guide d'onde non plus en silicium mais dans un matériau diélectrique moins sensible à la température et d'intégrer un tel filtre dans la structure d'une source laser. Ici, un matériau moins sensible à la température est un matériau dont la variation $dn_f/dT$ de son indice de réfraction en fonction de la température est au moins deux fois inférieure, dans les mêmes conditions, à la variation $dn_{Si}/dT$ de l'indice de réfraction du silicium en fonction de la température. Typiquement, la variation $dn_{Si}/dT$ est égale à $2.3 \times 10^{-4}$/°C à plus ou moins 20 % près. Ainsi, la variation $dn_f/dT$ est au moins inférieure à $1 \times 10^{-4}$ /°C et, de préférence, inférieure à $0.5 \times 10^{-4}$ /°C. Par la suite, la description est faite dans le cas particulier où le matériau moins sensible à la température est du nitrure de silicium (Si3N4) dont la variation dnf/dT est égale à $0.4 \times 10^{-4}$ /°C. Toutefois, comme décrit en détail à la fin de cette description, d'autres matériaux sont possibles. L'indice de réfraction du nitrure de silicium varie en fonction de la température six à sept fois moins vite que celui du silicium. Par conséquent, la longueur d'onde centrale $\lambda_{Cf}$ du filtre réalisé dans un guide d'onde en nitrure de silicium se déplace, en fonction de la température, uniquement de 0,01 nm/°C.

La figure 3 représente la position de la bande réfléchissante 4 et de la bande passante 6 dans le cas où le filtre est réalisé dans un guide d'onde en nitrure de silicium et pour une température de fonctionnement de la source laser de 33 °C. Comme le montre le graphe de la figure 3, la longueur d'onde centrale $\lambda_{Cf}$ du filtre se déplace uniquement de 0,13 nm (=0.01 x 13°C) en réponse à une augmentation de 13 °C de la température de fonctionnement de la source laser. Par contre, l'amplitude du déplacement de la longueur d'onde centrale $\lambda_{CR}$ est la même que dans le cas représenté sur la figure 2. Toutefois, le fait de seulement réaliser le filtre dans un matériau moins sensible à la température est déjà suffisant pour limiter très fortement la sensibilité de la longueur d'onde $\lambda_{Cf}$ à la température. Or, puisque c'est le filtre qui sélectionne la longueur d'onde $\lambda_{Li}$ d'émission de la source laser, il devient possible, après centrage d'une longueur d'onde $\lambda_{Rj}$ sur la longueur d'onde $\lambda_{Cf}$ d'obtenir un longueur d'onde $\lambda_{Li}$ d'émission de la source laser moins sensible à la température.

Comme on le verra par la suite, dans la source laser décrite, un dispositif d'accord, un capteur et un circuit électronique de commande sont utilisés pour centrer automatiquement et correctement la plus proche des longueurs d'onde $\lambda_{Rj}$ au centre de la bande passante 6 du filtre pour obtenir l'émission de la source laser sur la longueur d'onde $\lambda_{Li}$. En effet, puisque la bande passante 6 du filtre se déplace beaucoup moins rapidement que les longueurs d'onde $\lambda_{Rj}$ si rien n'est fait pour centrer correctement l'une des longueurs d'onde $\lambda_{Rj}$ au centre de la bande passante 6, cette bande passante 6 peut ne contenir aucune longueur d'onde $\lambda_{Rj}$ ou une longueur d'onde $\lambda_{Rj}$ mal centrée ce qui supprime l'émission de la source laser ou limite fortement la puissance du signal optique émis.

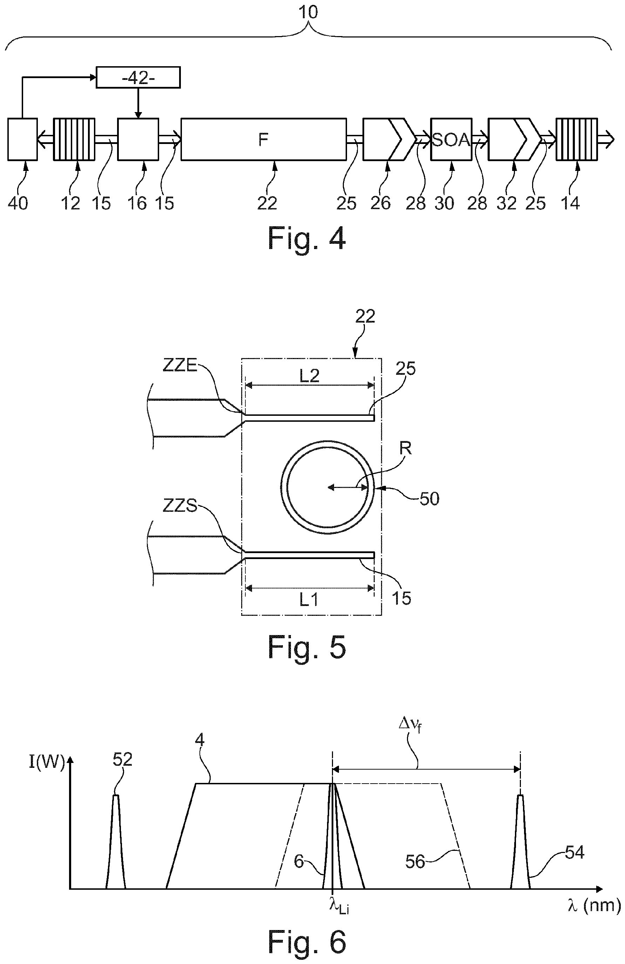

La figure 4 représente schématiquement l'architecture générale d'une source laser 10 à semi-conducteur monochromatique qui émet à la longueur d'onde $\lambda_{Li}$. La source laser 10 comporte un réflecteur arrière 12 et un réflecteur avant 14 qui définissent les extrémités de la cavité de Fabry-Pérot à l'intérieur de laquelle le signal optique résonne. Par exemple, le réflecteur 12 présente un facteur de réflexion strictement supérieur à celui du réflecteur 14. Le facteur de réflexion est égal au rapport entre la puissance du signal optique réfléchi par le réflecteur sur la puissance du signal optique incident sur ce réflecteur. Typiquement, le facteur de réflexion du réflecteur 12 est supérieur ou égal à 90 % ou 95 % pour la longueur d'onde $\lambda_{Li}$. Le facteur de réflexion du réflecteur 14 est généralement compris entre 30 % et 70 % et vaut typiquement 50 %.

Les réflecteurs 12 et 14 sont des réflecteurs large bande. Dans ce mode de réalisation, cela signifie que la largeur $\Delta R$ de la bande réfléchissante 4 des réflecteurs 12 et 14 est strictement supérieure à $\Delta\lambda_f + DT \times (d\lambda_{CR}/dT)$, où :

- $\Delta\lambda_f$ est la largeur de la bande passante 6 du filtre qui sélectionne la longueur d'onde $\Delta\lambda_{Li}$, exprimée en nanomètre,
- DT est la largeur de la gamme prédéterminée de températures de fonctionnement de la source laser 10, exprimée en °C,
- $d\lambda_{CR}/dT$ est la variation de la longueur d'onde centrale $\lambda_{CR}$ de la bande réfléchissante des réflecteurs 12 et 14 en fonction de la température, exprimée en nm/°C.

La gamme de températures de fonctionnement d'une source laser est souvent aujourd'hui choisie pour que, quelle que soit la température de fonctionnement de la source laser située à l'intérieur de cette gamme, cela ne provoque pas une variation de la longueur d'onde $\lambda_{Li}$ supérieure à 0,35 nm. Ainsi, par exemple, la largeur DT de cette gamme est supérieure à 10°C ou 30°C. Pour respecter ce critère, ici la gamme de températures de fonctionnement est choisie comme étant comprise entre +20°C et +55°C. La largeur DT est donc ici égale à 35 °C. Par la suite, la plus petite et la plus grande températures de la gamme de températures de fonctionnement sont notées, respectivement, $T_{min}$ et $T_{max}$. Dans ce mode de réalisation, les réflecteurs 12 et 14 sont réalisés dans un guide d'onde en silicium. Ainsi, la variation $d\lambda_{CR}/dT$ est ici égale à 0,07 nm/°C. Comme décrit en référence aux figures 1 à 3, la largeur $\Delta\lambda_f$ est inférieure à l'intervalle $\Delta\lambda_R$. Typiquement, l'intervalle $\Delta\lambda_R$ est inférieur ou égal à 0,5 nm. Par exemple, ici, l'intervalle $\Delta\lambda_R$ est égal est 0,3 nm à 15 % ou 30 % près. Ainsi, dans ce mode de réalisation, la largeur $\Delta\lambda_f$ est inférieure ou égale à 0,3 nm. La largeur $\Delta R$ est donc ici strictement supérieure à 2,75 nm (=0,07 x 35 + 0,3).

Les réflecteurs 12 et 14 sont également conçus pour que, à la température $T_{min}$, la longueur d'onde $\lambda_{Li}$ soit plus proche de la borne supérieure $\lambda_{Rmax}$ de la bande réfléchissante 4 que de sa borne inférieure $\lambda_{Rmin}$. Par exemple, à la température $T_{min}$, la longueur d'onde $\lambda_{Li}$ est comprise entre $0,9\ \lambda_{Rmax}$ et $\lambda_{Rmax}$. Cette contrainte peut être relâchée

si la largeur $\Delta R$ est très supérieure à $\Delta\lambda_f$ + DT x $(d\lambda_{CR}/dT)$. En effet, dans ce dernier cas, pour que la longueur d'onde $\lambda_{Li}$ soit contenue à l'intérieur de la bande réfléchissante 4 quelle que soit la température de fonctionnement de la source laser 10 comprise entre $T_{min}$ et $T_{max}$, il n'est pas nécessaire que longueur d'onde $\lambda_{Li}$ soit proche de $\lambda_{Rmax}$.

Ici, les réflecteurs 12 et 14 sont par exemple des réflecteurs tels que des réseaux de Bragg.

Entre les réflecteurs 12 et 14, la source laser comporte successivement les composants photoniques suivants en allant du réflecteur 12 vers le réflecteur 14 :

- un guide d'onde optique 15 en silicium dans lequel est réalisé le réflecteur 12,
- un dispositif d'accord 16 apte à déplacer les longueurs d'onde $\lambda_{Rj}$ en fonction d'un signal électrique de commande et en utilisant les propriétés du silicium du guide d'onde 15,
- un filtre passe-bande 22 apte à sélectionner la longueur d'onde $\lambda_{Li}$ de fonctionnement de la source laser 10 parmi les différentes longueurs d'onde $\lambda_{Rj}$ possibles à l'intérieur de la cavité de Fabry-Pérot, ce filtre 22 étant réalisé dans un guide d'onde en nitrure de silicium,
- un guide d'onde 25 en silicium,
- un coupleur adiabatique 26 qui raccorde optiquement le guide d'onde 25 à une entrée d'un guide d'onde 28 en matériau à gain III-V,
- un amplificateur optique 30 à semi-conducteur plus connu sous l'acronyme SOA (« Semiconductor Optical Amplifier ») réalisé dans le guide d'onde 28 et apte à générer et à amplifier le signal optique résonant à l'intérieur de la cavité de Fabry-Pérot à chaque longueur d'onde $\lambda_{Rj}$,
- un coupleur adiabatique 32 qui raccorde optiquement une sortie du guide d'onde 28 au guide d'onde 25 dans l'extrémité duquel est réalisé le réflecteur 14.

Par la suite, seules les particularités de la source laser 10 sont décrites en détail. Pour des informations générales sur la réalisation et le fonctionnement d'une source laser à semi-conducteur utilisant des guides d'onde en silicium et en matériau à gain III-V, le lecteur peut consulter l'article suivant : B. Ben Bakir et al., « Hybrid Si/III-V lasers with adiabatic coupling », 2011.

Pour une description détaillée d'un coupleur adiabatique, le lecteur est renvoyé à l'article suivant : Amnon Yariv et al., « Supermode Si/III-V hybrid Lasers, optical amplifiers and modulators: proposai and analysis » Optics Express 9147, vol. 14, No. 15, 23/07/2007.

En particulier, il est rappelé qu'un coupleur adiabatique est apte à transformer un mode optique guidé dans un premier guide d'onde en silicium en un mode optique guidé dans un second guide d'onde en matériau à gain III-V. En particulier, un coupleur adiabatique est apte à transférer la quasi-totalité du signal optique présent dans le premier guide d'onde vers le second guide d'onde situé au-dessus ou en dessous, sans réflexion. Par exemple, la puissance du signal optique transférée dans le second guide d'onde est supérieure ou égale à 95 % de la puissance du signal optique qui circule dans le premier guide d'onde. Un tel coupleur adiabatique est, par exemple, obtenu en modifiant la largeur du premier guide d'onde par rapport à la largeur du second guide d'onde. Typiquement pour un couplage adiabatique d'un guide d'onde en silicium vers un guide d'onde en matériau III-V, la largeur du guide d'onde en silicium est progressivement réduite à l'approche du guide d'onde en matériau III-V. En sens inverse, pour transférer par couplage adiabatique un signal optique du guide d'onde en matériau III-V vers le premier guide d'onde en silicium, la largeur guide d'onde en silicium est par exemple progressivement augmentée. De plus, les guides d'onde en silicium et en matériau III-V ont généralement une largeur telle que leur indice respectif de propagation sont égaux. Ceci est aussi vrai pour un couplage adiabatique entre des guides d'onde hybrides Si/ matériau III-V.

Dans ce mode de réalisation, le filtre 22 est un filtre en anneau résonant dont l'anneau est réalisé dans un guide d'onde 50 (figure 5) en Si3N4. De préférence, le guide d'onde 50 dans lequel est réalisé l'anneau est directement raccordé optiquement aux guides d'onde 15 et 25 en silicium par couplage évanescent. Un couplage évanescent entre un guide d'onde en silicium et un guide d'onde en nitrure de silicium est obtenu en rapprochant ces deux guides d'onde l'un de l'autre et en égalisant les indices de propagation des deux guides d'onde rapprochés.

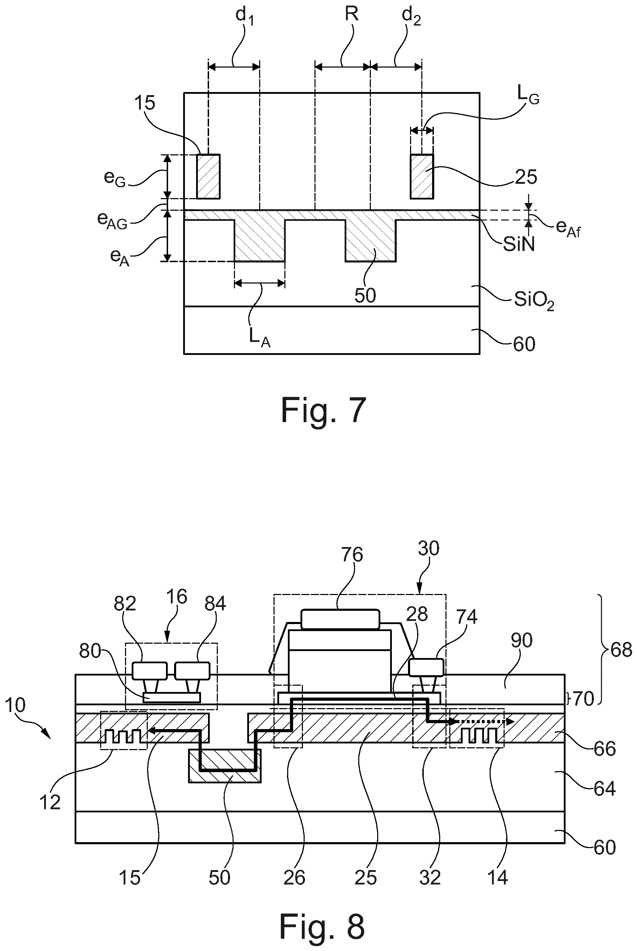

Un couplage évanescent entre un premier et un second guide d'onde transfère une fraction de la puissance du signal optique présent dans le premier guide d'onde vers le second guide d'onde. Cette fraction de la puissance est ajustée en jouant, par exemple, sur la distance entre les premier et second guides d'onde. Ici, la géométrie et la distance entre les guides d'onde 15, 25 et le guide d'onde 50 dans lequel est réalisé l'anneau du filtre 22 sont ajustées pour que la puissance du signal optique transférée entre le guide d'onde en silicium et le guide d'onde 50 soit comprise entre 5 % et 25 % et, de préférence, égale à 10 % à plus ou moins 3 % ou 1 % près. Les géométries des guides d'onde sont modifiées pour égaliser les indices de propagation dans les deux guides d'onde. Ici la largeur des guides d'onde 15 et 25 en silicium est par exemple réduite sur une longueur L1 et L2 respectivement, et celle du guide d'onde 50 en $Si_3N_4$ n'est pas modifiée. Pour ajuster la puissance couplée, la distance entre les deux guides d'onde 15 et 50 et 25 et 50 est ajustée dans une direction horizontale à une distance calculée $d_1$, respectivement $d_2$, comme cela est décrit plus en détail en référence aux figures 5 et 7.

L'utilisation d'un couplage évanescent entre le guide d'onde 50 de l'anneau et les guides d'onde 15 et 25 en silicium permet de limiter l'encombrement de la source laser en évitant le recours à des coupleurs adiabatiques et à des guides d'onde supplémentaires en nitrure de silicium.

Les couplages adiabatiques ou évanescents présentent également l'avantage de limiter les réflexions des signaux optiques au niveau de du raccordement optique entre les deux guides d'onde.

Pour générer le signal électrique de commande du dispositif d'accord 16, la source laser 10 comporte également :

- un capteur 40 apte à mesurer une grandeur physique représentative de l'écart entre la longueur d'onde $\lambda_{Cf}$ et la plus proche des longueurs d'onde $\lambda_{Rj}$, et
- un circuit électronique 42 apte à générer le signal électrique de commande du dispositif d'accord 16 de manière à maintenir en permanence une longueur d'onde $\lambda_{Rj}$ au centre de la bande passante 6 du filtre 22.

A cet effet, ici, le capteur 40 mesure la puissance du signal optique émis par la source laser 10. Dans ce mode de réalisation, la source laser 10 comporte deux sorties possibles pour le signal optique résonant à savoir soit en traversant le réflecteur 14 soit en traversant le réflecteur 12. Étant donné que le facteur de réflexion du réflecteur 12 est plus grand que celui du réflecteur 14, le signal optique qui sort en traversant le réflecteur 12 a une puissance beaucoup plus faible que celui qui sort en traversant le réflecteur 14. Classiquement, le signal optique qui sort en traversant le réflecteur 14 est appelé « signal optique utile » et celui qui sort en traversant le réflecteur 14 est appelé « signal optique de pilotage » ou « signal optique de monitoring ». Ici, le capteur 40 mesure la puissance du signal optique qui traverse le réflecteur 12. Par exemple, le capteur 40 comporte un photo-détecteur qui mesure la puissance du signal optique. La puissance ainsi mesurée est transmise au circuit électronique 42. Cette puissance mesurée est représentative de l'écart entre les longueurs d'onde $\lambda_{Cf}$ et la plus proche des longueurs d'onde $\lambda_{Rj}$. En effet, la puissance mesurée est maximale quand la longueur d'onde $\lambda_{Cf}$ est alignée avec l'une des longueurs d'onde $\lambda_{Rj}$. Cette puissance diminue continûment au fur et à mesure que la longueur d'onde $\lambda_{Rj}$ s'éloigne de la longueur d'onde $\lambda_{Cf}$ tant que l'on reste à l'intérieur d'un intervalle de largeur $\Delta\lambda_R$ centré sur la longueur d'onde $\lambda_{Cf}$.

Le circuit électronique 42 construit le signal de commande qui permet de maintenir une longueur d'onde $\lambda_{Rj}$ au centre de la bande passante 6 en fonction de la grandeur physique mesurée par le capteur 40. À cet effet, il est raccordé électriquement au capteur 40. De plus, il est raccordé électriquement au dispositif d'accord 16 pour lui transmettre le signal électrique de commande généré. Typiquement, le capteur 40 est réalisé sur le même substrat que les autres composants photoniques de la source laser 10 et par exemple dans le matériau à gain III-V. Le circuit électronique 42 est souvent rapporté sur ce substrat.

La figure 5 représente plus en détail le filtre 22 dans le cas où celui-ci est réalisé à l'aide d'un anneau résonant. cet effet, le guide d'onde 50 forme un anneau directement raccordé optiquement, respectivement, aux guides d'onde 15 et 25 uniquement par couplages évanescents. Cet anneau est donc réalisé en nitrure de silicium tandis que les guides d'onde 15 et 25 sont réalisés en silicium. Sur cette figure 5 les entrée et sortie du filtre 22 sont notées, respectivement, ZZE et ZZS. A

Comme représenté sur la figure 6, le spectre de transmission du filtre 22 présente plusieurs bandes passantes régulièrement espacées les unes des autres. Ici, les fréquences centrales de deux bandes passantes successives sont espacées l'une de l'autre par un intervalle $\Delta v_f$. Cet intervalle $\Delta v_f$ est plus connu sous l'acronyme FSR (« Free Spectral Range »). Sur le graphe de la figure 6, seule la bande passante 6 et deux bandes passantes 52 et 54 situées, respectivement, avant et après la bande passante 6 sont représentées.

Ici, les dimensions du filtre 22 sont déterminées par simulation numérique ou expérimentalement pour que l'intervalle $\Delta v_f$ soit strictement supérieur à la larguer $\Delta R$ de la bande réfléchissante 4. Ainsi, une seule des bandes passantes du filtre 22, c'est-à-dire ici la bande passante 6, se trouve à l'intérieur de la bande réfléchissante 4 quelle que soit la température de fonctionnement. Dès lors, le filtre 22 permet de sélectionner uniquement une seule longueur d'onde $\lambda_{Rj}$ de sorte que la source laser 10 est une source laser monochromatique. Sur le graphe de la figure 6, la longueur d'onde sélectionnée est représentée par une barre verticale d'abscisse $\lambda_{Li}$.

Par exemple, les valeurs de la longueur d'onde $\lambda_{Cf}$ et de l'intervalle $\Delta v_f$ sont fixées à partir des paramètres suivants : le périmètre de l'anneau, l'indice $n_{eff}$ de propagation dans le guide d'onde 50, l'indice $n_g$ de groupe dans le guide d'onde 50 (« refractive group index » en anglais) et l'ordre de résonance K. A titre d'illustration, la longueur d'onde $\lambda_{Cf}$ et de l'intervalle $\Delta v_f$ sont estimés à l'aide des relations suivantes :

$$\lambda_{Cf} = \frac{perimeter \cdot n_{eff}(\lambda)}{K} \qquad \Delta \nu_f \approx \frac{\lambda^2}{perimeter \cdot n_g}$$

où « perimeter » est le périmètre de l'anneau réalisé dans le guide d'onde 50 et λ est la longueur d'onde du signal optique pour laquelle la longueur d'onde $\lambda_{Cf}$ et l'intervalle $\Delta \nu_f$ sont calculés.

La largeur $\Delta \lambda_f$ peut être déterminée par les pertes de propagation dans le guide d'onde 50 de l'anneau et les coefficients de couplage évanescent du guide d'onde 50 avec les guides d'ondes 15 et 25.

Le graphe de la figure 6 a été représenté dans le cas où la température de fonctionnement est égale à $T_{min}$. La ligne en pointillés 56 représente la position de la bande réfléchissante 4 lorsque la température de fonctionnement est égale à $T_{max}$. Comme illustré sur le graphe de la figure 6, quelle que soit la température de fonctionnement de la source laser comprise entre $T_{min}$ et $T_{max}$, la bande passante 6 est toujours située à l'intérieur de la bande réfléchissante 4 même si celle-ci se déplace à cause des variations de température. Sur le graphe de la figure 6, le léger déplacement de la bande passante 6 en fonction de la température n'a pas été représenté.

Les dimensions du filtre 22 sont également déterminées pour obtenir les propriétés souhaitées des couplages évanescents entre le guide d'onde 50 de l'anneau et les guides d'ondes 15 et 25 et en particulier le taux de transfert de puissance entre les guides d'ondes 15, 25 et et le guide d'onde 50. Par exemple, les dimensions du filtre 22 déterminées sont notamment choisies parmi les dimensions suivantes :

- le rayon de l'anneau R,
- des longueurs L1 et L2 sur lesquelles la largeur des guides d'onde 15 et 25 sont réduites de façon à égaliser les indices de propagation dans les guides d'onde 15 et 25 et 50,
- les distances $d_1$ et $d_2$,
- les épaisseurs $e_A$, $e_{Af}$ et la largeur $L_A$ du guide d'onde 50 du filtre 22,
- l'épaisseur $e_G$ et la largeur $L_G$ des guides d'onde 15 et 25 dans le cas d'un couplage évanescent,
- l'espace vertical eAG en oxyde de silicium qui sépare le guide d'onde 50 et les guides d'onde 15 et 25.

Les dimensions L1 et L2 sont représentées sur la figure 5. Les dimensions $d_1$, $d_2$, $e_G$, $L_G$, $e_{AG}$, $e_A$ $e_{Af}$, et $L_A$ sont représentées dans une coupe verticale passant par le centre de l'anneau 50 et perpendiculaire aux guides d'onde 15 et 25 sur la figure 7. Dans cette coupe, les guides d'onde 15 et 25 et 50 sont situés dans des couches horizontales respectives superposées l'une au-dessus de l'autre dans la direction verticale. Ces couches sont parallèles au plan dans lequel s'étend principalement un substrat 60, sur lequel les différentes couches utilisées pour fabriquer la source laser 10 sont empilées. Ce plan est par la suite appelé « plan du substrat ». Dans les figures qui suivent, le plan du substrat est toujours horizontal.

À titre d'illustration, typiquement :

- les distances $d_1$ et $d_2$ sont comprises entre 0 μm et 3 μm,
- l'épaisseur $e_G$ est comprise entre 100 nm et 500 nm,
- la largeur $L_G$ est comprise entre 100 nm et 500 nm,
- l'épaisseur $e_{AG}$ est comprise entre 0 nm et 200 nm,
- l'épaisseur $e_A$ est comprise entre 50 nm et 700 nm,
- la largeur $L_A$ est comprise entre 500 nm et 1 μm,
- le rayon de l'anneau 50 est compris entre 3 μm et 100 μm.

Par exemple, pour obtenir un taux de transfert de puissance de 10 % entre le guide d'onde 15 et le guide d'onde 50 de l'anneau, des dimensions possibles sont les suivantes : R = 30 μm, L1 = 60 μm, $e_G$ = 300 nm, eAG = 50 nm, $L_G$ = 180 nm, $e_A$ = 500nm, $e_{Af}$ = 50 nm, $L_A$=700 nm, $d_1$ = 1,1 μm.

La figure 8 représente un premier exemple de mode de réalisation de la source laser 10. La source laser 10 est réalisée à l'aide des mêmes procédés de fabrication que ceux utilisés pour fabriquer des composant CMOS (« Complementary Metal-Oxyde Semi-conductor »). Ici, la source laser 10 est fabriquée sur le substrat 60 en silicium qui s'étend horizontalement.

Sur la figure 8, la source laser 10 comporte successivement empilés au-dessus du substrat 60 en allant du bas vers le haut :

- une couche 64 de nitrure de silicium encapsulée dans de l'oxyde de silicium et qui contient le guide d'onde 50,
- une couche 66 de silicium encapsulé dans de l'oxyde de silicium dans laquelle sont réalisés les guides d'onde 15 et 25 et les réflecteurs 12 et 14,
- une couche 68 comportant le guide d'onde 28 à l'intérieur duquel est réalisé l'amplificateur 30.

Les coupleurs adiabatiques 26 et 32 sont réalisés en partie dans le guide d'onde 25 et dans le guide d'onde 28.

De préférence, l'amplificateur 30 est un amplificateur large bande, c'est-à-dire capable de générer et d'amplifier une plage importante de longueurs d'onde. Cette plage comprend la longueur d'onde $\lambda_{Li}$. Typiquement, elle est centrée sur cette longueur d'onde $\lambda_{Li}$ à la température $(T_{max}+T_{min})/2$. La largeur de cette plage de longueur d'onde à -3 dB est par exemple d'au moins 10 nm ou 25 nm ou 35nm et reste large avec l'augmentation de température. Par exemple, les matériaux III-V constituant l'amplificateur 30 sont ceux décrits dans l'article suivant : Dimitris Fitsios et al. « High-gain 1,3 $\mu$m GaInNAs semiconductor optical amplifier with enchanced temperature stability for all-optical processing at 10 Gb/s », Applied optics, may 2015 vol. 54, n°1, 1er janvier 2015. Le fait de réaliser l'amplificateur 30 comme décrit dans cet article permet en plus d'obtenir un amplificateur large bande stable en température. Cela améliore le fonctionnement de la source laser et notamment cela permet de maintenir une puissance émise par la source laser presque constante dans toute la gamme de températures de fonctionnement $[T_{min} ; T_{max}]$. Dans ce cas, le guide d'onde 28 et l'amplificateur 30 se présentent sous la forme d'un empilement de sous-couches en alternance en GaInNAs et en GaNAs interposées entre une sous-couche inférieure 70 et une sous-couche supérieure en GaAs dopé P. La sous-couche 70 est une sous-couche en matériau III-V de dopage opposé à la sous couche supérieure. Par exemple, ici, il s'agit d'une sous-couche en GaAs dopé N.

L'amplificateur 30 comporte, en plus du guide d'onde 28, une prise 74 directement en contact mécanique et électrique avec la portion de la sous-couche 70 située sous l'empilement de sous-couches en GaInNAs et GaNAs. La sous-couche en GaAs dopée P est en contact mécanique et électrique avec une prise 76 pour raccorder électriquement la partie supérieure de l'amplificateur 30 à un potentiel. Lorsqu'un courant supérieur au courant de seuil du laser est appliqué entre les prises 74 et 76, l'amplificateur 30 génère et amplifie le signal optique qui résonne à l'intérieur de la cavité de Fabry-Pérot.

Le dispositif d'accord 16 est ici une chaufferette apte à chauffer le guide d'onde 15 pour déplacer les longueurs d'onde $\lambda_{Rj}$.

Dans ce mode de réalisation, le dispositif d'accord 16 comprend une résistance 80 électriquement raccordée à deux prises 82 et 84 de contact électrique permettant de faire circuler un courant dans cette résistance 80 de manière à transformer l'énergie électrique en chaleur. Ces prises 82 et 84 sont électriquement raccordées à une source de courant ou de tension commandée par le circuit électronique 42 en fonction des mesures du capteur 40. La commande du dispositif d'accord 16 consiste donc ici à régler la puissance électrique qui traverse la résistance 80. Faire circuler un courant dans la résistance 80 permet de chauffer le guide d'onde 15 et donc de déplacer les longueurs d'onde $\lambda R_j$.

La résistance 80 est ici une bande réalisée dans la sous-couche 70. Cette bande est donc une bande en GaAs dopée N. Dans ce mode de réalisation, elle est logiquement située au-dessus du guide d'onde 15 dont la variation d'indice $dn_{Si}/dT$ est nettement supérieure à la variation d'indice $dn_f/dT$.

Le dispositif d'accord 16, le guide d'onde 28 et l'amplificateur 30 sont recouverts d'une enveloppe protectrice 90 qui les isole mécaniquement de l'extérieur. Seules les prises 74, 76, 82, 84 font saillie au-delà de l'enveloppe 90. Par exemple, l'enveloppe 90 est réalisée en nitrure de silicium.

Le trajet du signal optique résonant dans la source laser 10 est représenté sur la figure 8 par une double flèche.

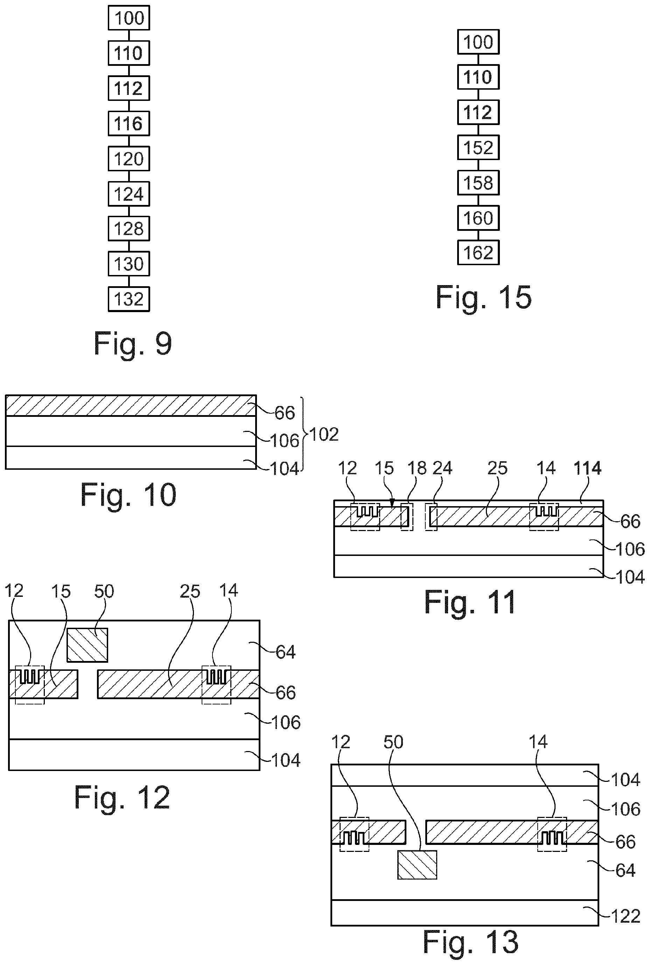

Un procédé de fabrication de la source laser 10 va maintenant être décrit en référence au procédé de la figure 9 et à l'aide des figures 10 à 14.

Lors d'une étape 100, le procédé commence par la fourniture d'un substrat SOI 102 (Silicium-On-Insulator). Ce substrat 102 (figure 10) comporte successivement les couches suivantes empilées les unes au-dessus des autres en allant du bas vers le haut :

- un substrat 104 en silicium,
- une couche 106 d'oxyde de silicium, et
- la couche 66 de silicium.

Lors d'une étape 110, les guides d'onde 15 et 25 et les réflecteurs 12 et 14 sont fabriqués dans la couche 66 en silicium. Par exemple, ils sont fabriqués par photolithographie et gravure de cette couche 66. Lors de cette étape, les parties des coupleurs 26 et 32 qui se trouvent dans la couche 66 sont également réalisées.

Lors d'une étape 112, la couche 66 est encapsulée dans une couche 114 (figure 11) d'oxyde de silicium. Cette couche 114 est polie, c'est-à-dire planarisée, par exemple, par un procédé de polissage physico-chimique, plus connu sous l'acronyme CMP (« Chimical-Mechanical Planarization »), afin de planariser la face supérieure de cette couche 114.

Lors d'une étape 116, une couche en nitrure de silicium est déposée sur la face supérieure de la couche 114.

Ensuite, cette couche en nitrure de silicium est gravée pour former le guide d'onde 50 puis encapsulé dans de l'oxyde de silicium. Sur la figure 12 et les suivantes, pour simplifier ces figures, le guide d'onde 50 est représenté sous la forme d'un bloc de nitrure de silicium. On obtient alors la couche 64 (figure 12) de nitrure de silicium encapsulée dans de l'oxyde de silicium. La face supérieure de la couche 64 est ensuite polie, par exemple, comme décrit en référence à l'étape 112.

Lors d'une étape 120, un substrat 122 (figure 13) est collé sur la face extérieure en oxyde de silicium de la couche 64. Le substrat 122 est un substrat en silicium qui comprend au dessus une couche épaisse d'oxyde de silicium. Ce sont ces couches d'oxyde de silicium qui sont collées l'une sur l'autre.

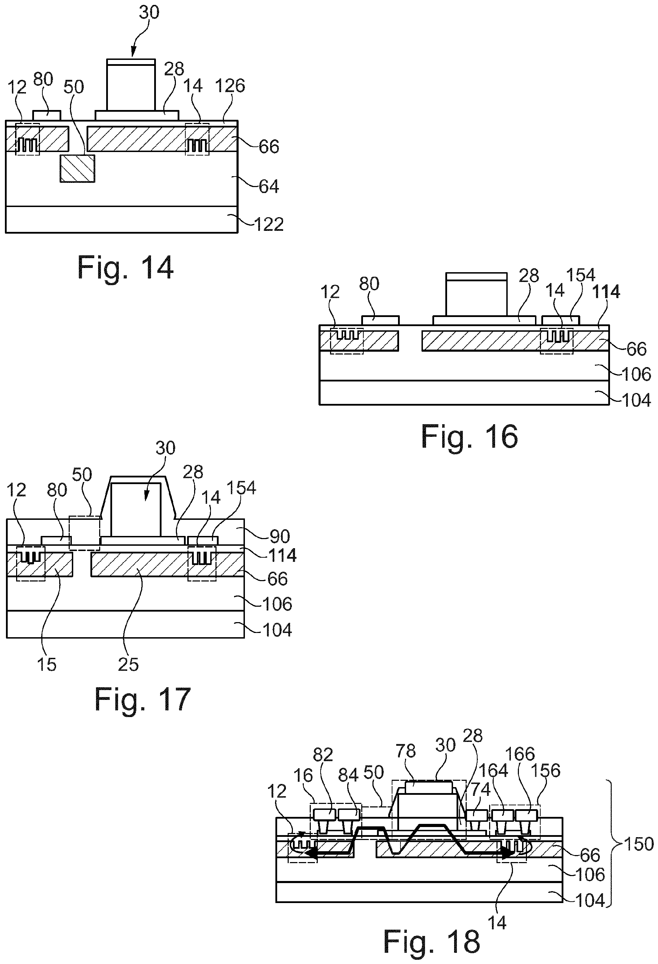

Lors d'une étape 124, la couche 104 en silicium est retirée, et la couche 106 est amincie pour ne laisser qu'une fine couche intermédiaire 126 (figure 14) d'oxyde de silicium. La face extérieure de la couche 126 est polie comme décrit en référence à l'étape 112.

Lors d'une étape 128, la couche 68 en matériau à gain III-V est collée ou déposée sur la couche 126. Par exemple, la couche 68 (figure 8) en matériau à gain III-V est collée sur la face extérieure de la couche 126. La couche 68 comprend la sous-couche inférieure 70, l'empilement de sous-couches en alternance en GaInNAs et en GaNAs et la sous-couche supérieure dopée.

Une fois l'étape 128 réalisée, lors d'une étape 130, la couche 68 est gravée pour fabriquer le guide d'onde 28, l'amplificateur 30 et la résistance 80. Typiquement, au cours d'une première gravure, les sous-couches supérieures de la couche 68 sont gravées pour structurer l'amplificateur 30. Ensuite, lors d'une deuxième gravure, la sous couche 70 est gravée pour finaliser la structuration de amplificateur 30 et pour réaliser la résistance 80.

Enfin, lors d'une étape 132, l'enveloppe 90 et les prises 74, 76, 82 et 84 sont réalisées. On obtient alors la source laser dont une vue en coupe est représentée sur la figure 8.

La figure 15 représente un deuxième procédé de fabrication d'une source laser 150 (figure 18). Ce procédé débute par les étapes 110 et 112 déjà décrites en référence au procédé de la figure 9.

Ensuite, il se poursuit par une étape 152 où une couche identique à la couche 68 précédemment décrite est collée ou déposée sur la couche 114 (figure 16). Typiquement, cette couche est collée par collage moléculaire.

Ensuite, lors d'une étape 158, cette couche est gravée pour fabriquer le guide d'onde 28, l'amplificateur 30, la résistance 80 et une résistance additionnelle 154 (figure 16). Par exemple, ceci est réalisé comme décrit en référence à l'étape 128.

La résistance 154 est utilisée pour réaliser un dispositif d'accord 156 (figure 18) par exemple identique au dispositif d'accord 16, sauf que celui-ci permet de déplacer la bande réfléchissante 4 du réflecteur 14 en fonction d'un signal électrique de commande généré par le circuit électronique 42. Ce signal électrique de commande du dispositif d'accord 156 est typiquement généré en fonction des mesures du capteur 40. Cela permet de réduire si nécessaire la largeur $\Delta R$ de la bande réfléchissante des réflecteurs. Par exemple, dans ce cas, elle peut être aussi petite que $N \times \Delta v_f$.

La résistance 154 est située au-dessus du réflecteur 14.

Lors d'une étape 160, l'enveloppe protectrice 90 est réalisée. Lors de cette étape, le guide d'onde 50 est fabriqué dans l'enveloppe 90 qui est en nitrure de silicium. Par exemple, le guide d'onde 50 est fabriqué par photolithographie et gravure de l'enveloppe 90 à proximité des extrémités des guides d'onde 15 et 25 (figure 17).

Lors d'une étape 162, les prises 74, 76, 82 et 84 sont fabriquées. Des prises de contact 164 et 166 qui raccordent mécaniquement et électriquement la résistance 154 sont également fabriquées pour faire circuler un courant dans cette résistance 154. La combinaison de la résistance 154 et des prises 164 et 166 forme le dispositif d'accord 156. On obtient alors la source laser 150 représentée sur la figure 18.

Sur la figure 18, le trajet du signal optique résonant dans la source laser 150 est représenté par une double flèche.

La source laser 150 est identique à la source laser 10, sauf que le guide d'onde 50 et le guide d'onde 28 sont tous les deux disposés du même côté de la couche 66. De plus, dans la source laser 150, les réflecteurs 12 et 14 sont tournés vers le haut et non pas vers le bas, comme dans la source laser 10. Ceci permet de raccorder la sortie du réflecteur 14 à une fibre optique arrivant par le dessus de la source laser 150.

Le fonctionnement de la source laser 150 est le même que celui de la source laser 10, sauf que le circuit électronique 42 est ici en plus adapté pour commander le dispositif d'accord 156 de manière à accorder en plus les réflecteurs 12 et 14.

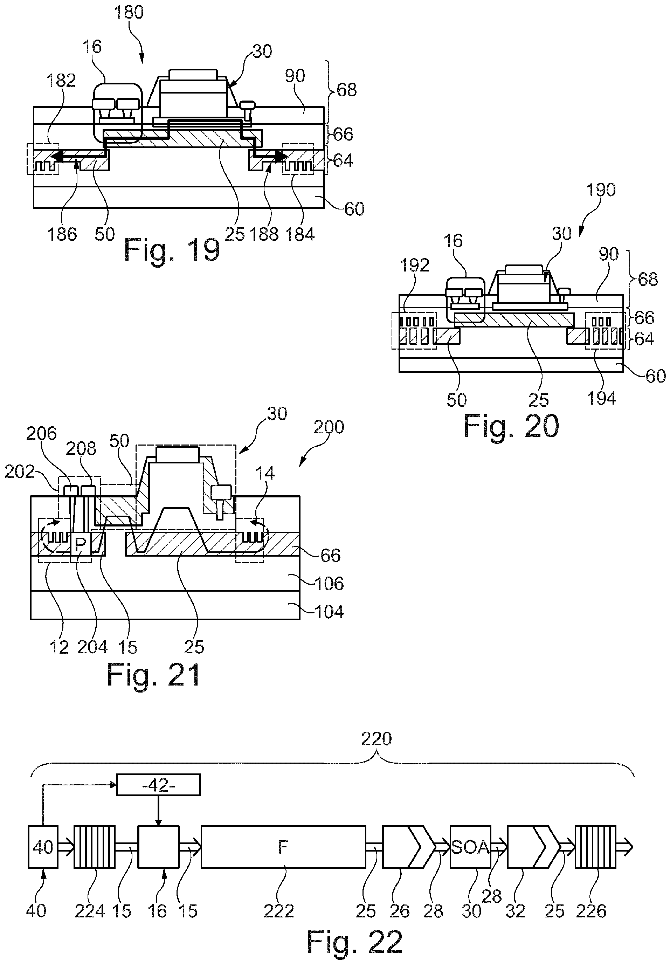

La figure 19 représente une source laser 180 identique à la source laser 10, sauf que :

- les réflecteurs 12 et 14 sont remplacés par, respectivement, des réflecteurs 182, 184, et
- le dispositif d'accord 16 est situé, par exemple, au-dessus du guide d'onde 25 et non plus au-dessus du guide d'onde 15.

Les réflecteurs 182, 184 sont identiques, respectivement, aux réflecteurs 12 et 14 sauf qu'ils sont réalisés dans la même couche en nitrure de silicium que le guide d'onde 50. Par exemple, ici, le réflecteur 182 est réalisé à une extrémité d'un guide d'onde 186 en nitrure de silicium dont l'autre extrémité est raccordée optiquement au guide d'onde 50 de l'anneau du filtre 22 par couplage évanescent. Par conséquent, le guide d'onde 15 est omis. Le guide d'onde 50 de l'anneau est raccordé optiquement au guide d'onde 25 par un couplage évanescent comme décrit précédemment. De façon similaire, le réflecteur 184 est réalisé à l'extrémité d'un guide d'onde 188 en nitrure de silicium dont l'autre extrémité est raccordée optiquement, par un couplage adiabatique, au guide d'onde 25.

Dans ce cas, de préférence, la largeur $\Delta R$ de la bande réfléchissante des réflecteurs 182 et 184 est supérieure à DT x ($d\lambda_{Cf}/dT$).

Les coupleurs qui raccordent optiquement entre eux les guides d'onde 25 et 28 sont des coupleurs adiabatiques.

On peut noter que le fait de réaliser les réflecteurs 182 et 184 dans un guide d'onde en nitrure de silicium, permet de diminuer leur largeur de bande. Ceci permet aussi de diminuer l'intervalle $\Delta\nu_f$ du filtre 22 pour obtenir une source laser monochromatique.

Sur la figure 19, le trajet du signal optique résonant est représenté par une double flèche.

La source laser 180 présente l'avantage que la bande réfléchissante 4 des réflecteurs 182 et 184 se déplace beaucoup moins rapidement que dans les sources laser 10 ou 150. En effet, dans ce mode de réalisation, la variation $d\lambda_{CR}/dT$ de la longueur d'onde centrale $\lambda_{CR}$ est égale à la variation $d\lambda_{Cf}/dT$. Ainsi, quelle que soit la variation de température, la bande passante 6 reste toujours à l'intérieur de la bande réfléchissante 4 et ne se déplace pas par rapport aux bornes supérieure et inférieure de cette bande réfléchissante 4. La largeur $\Delta R$ de la bande réfléchissante 4 peut alors être réduite. Typiquement, la largeur $\Delta R$ est alors strictement supérieure à DT x $d\lambda_{Cf}/dT + \Delta\lambda_f$.

La figure 20 représente une source laser 190 identique à la source laser 180, sauf que les réflecteurs 12 et 14 sont remplacés par des réflecteurs 192 et 194 en partie réalisés dans la couche 64 et en partie dans la couche 66. Ainsi, les réflecteurs sont réalisés en partie en nitrure de silicium et en partie en silicium. Typiquement, chaque réflecteur 192 et 194 est formé de deux réseaux de Bragg en vis-à-vis, un dans le guide d'onde en nitrure de silicium et un dans le guide d'onde en silicium.

La figure 21 représente une source laser 200 identique à la source laser 150, sauf que le dispositif d'accord 16 est remplacé par un dispositif d'accord 202. Le dispositif d'accord 202 comporte une section dopée P ou N formant une résistance 204 réalisée dans l'un des guides d'onde 15 ou 25. Sur la figure 21, la section 204 est réalisée dans le guide d'onde 15. Le dispositif d'accord 202 comporte aussi des prises 206 et 208 pour raccorder la résistance 204 au circuit électronique 42. Le fonctionnement de la source laser 200 se déduit de celui de la source laser 150.

La figure 22 représente une source laser 220 N-longueurs d'onde ou poli-chromatique. La source laser 220 est identique à la source laser 10, sauf que le filtre 22 est remplacé par un filtre 222, et les réflecteurs 12 et 14 sont remplacés, respectivement, par des réflecteurs 224 et 226.

Le filtre 222 est identique au filtre 22, sauf que les dimensions du filtre 222 sont modifiées de manière à ce qu'il présente plusieurs bandes passantes situées simultanément à l'intérieur de la bande réfléchissante des réflecteurs 224 et 226. Dans ce mode de réalisation, le filtre 222 est un anneau résonant réalisé dans le guide d'onde 50 raccordé optiquement aux guides d'onde 15 et 25 par des couplages évanescents.

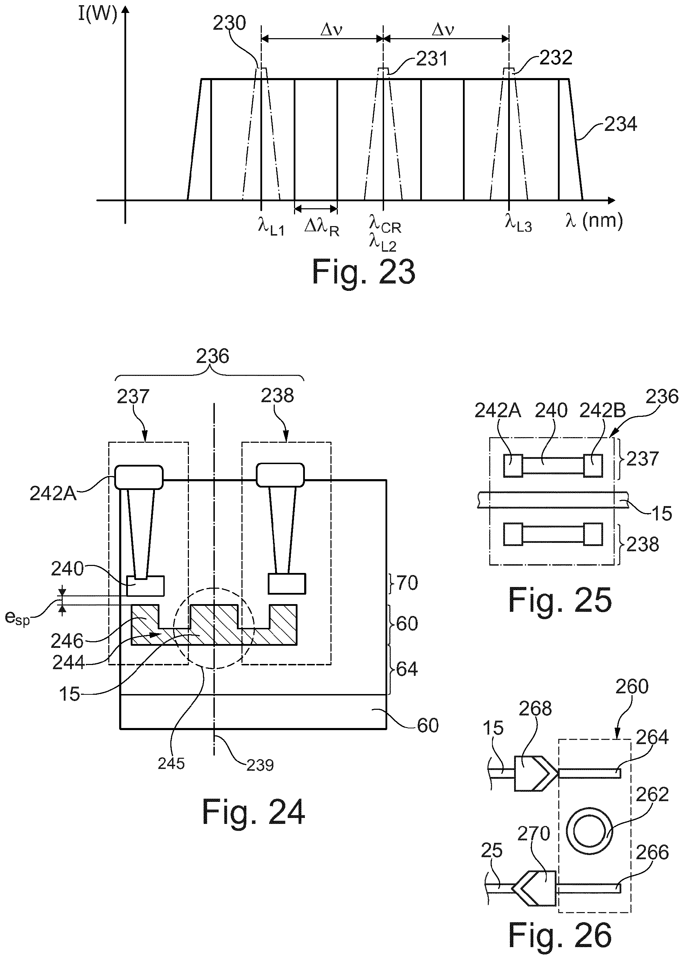

Sur le graphe de la figure 23, trois bandes passantes 230 à 232 du filtre 222 sont représentées comme étant situées à l'intérieur de la bande réfléchissante 228 des réflecteurs 224 et 226. Les longueurs d'onde centrales de ces bandes passantes sont notées, respectivement, $\lambda_{Cf1}$, $\lambda_{Cf2}$, et $\lambda_{Cf3}$. Dans le cas d'une source laser multi-longueurs d'onde, le symbole $\lambda_{Cf}$ est utilisé pour désigner l'une quelconque des longueurs d'onde centrale $\lambda_{Cf1}$, $\lambda_{Cf2}$, et $\lambda_{Cf3}$. Chacune de ces bandes passantes 230 à 232 est par exemple identique à la bande passante 6. De plus, l'intervalle $\Delta\nu_f$ entre deux de ces bandes passantes successives est un multiple entier de l'intervalle $\Delta\lambda_R$ et strictement inférieur à la largeur $\Delta R$ de la bande réfléchissante 234.

De préférence, la largeur $\Delta R$ de la bande réfléchissante 234 des réflecteurs 224 et 226 est :

- supérieure à DT x ($d\lambda_{CR}/dT$) si N x $A\nu_f$ < DT x ($d\lambda_{CR}/dT$), et
- supérieure à N x $\Delta\nu_f$ + DT x ($d\lambda_{Cf}/dT$) si N x $A\nu_f$ > DT x $d\lambda_{CR}/dT$,

où N est un nombre entier supérieur ou égal à deux et égal au nombre de longueurs d'onde $\lambda_{Rj}$ sélectionnées par le filtre 222.

Le fonctionnement de la source laser 220 est identique à celui de la source laser 10 sauf qu'elle émet simultanément N longueurs d'onde notées ici $\lambda_{L1}$, $\lambda_{L2}$ et $\lambda_{L3}$.

Les figures 24 et 25 représentent un dispositif 236 d'accord susceptible de remplacer avantageusement le dispositif 16. La figure 24 est une vue, en coupe verticale du dispositif 236 le long d'un plan de coupe transversal perpendiculaire au guide d'onde 15. Comme le dispositif 16, le dispositif 236 est apte à chauffer le guide d'onde 15 en silicium en fonction d'un signal électrique de commande. Le dispositif 236 comporte deux chaufferettes 237 et 238 symétriques l'une de l'autre par rapport à un plan vertical 239 (figure 24) passant par le centre du guide d'onde 15. Pour simplifier la description, seule la chaufferette 237 est décrite en détail. La chaufferette 237 comporte, par exemple, les mêmes éléments que le dispositif 16. En particulier, elle comporte une résistance 240 réalisée dans la sous-couche 70 et deux prises 242A et 242B de contact pour faire circuler un courant dans la résistance 240. Sur la figure 24, seule une prise 242A est visible.

La chaufferette 237 comporte en plus un bras latéral 244 réalisé en silicium dans la couche 60 est en continuité thermique avec le guide d'onde 15. Ce bras 244 s'étend dans une direction transversale horizontale depuis le guide d'onde 15 vers la gauche. Son épaisseur dans la direction verticale est inférieure à celle du guide d'onde 15. Plus précisément, ses dimensions sont telles que le signal optique ne peut pas se propager à l'intérieur du bras 244 et reste principalement confiné à l'intérieur d'une zone 245 qui entoure le guide d'onde 15. A son extrémité opposée au guide d'onde 15, dans ce mode de réalisation, le bras 244 présente une portion distale 246 en vis-à-vis de la résistance 240. La portion distale 246 est séparé de la résistance 240 par une fine couche d'oxyde de silicium d'épaisseur $e_{SP}$. Typiquement, l'épaisseur $e_{SP}$ est égale à l'épaisseur d'oxyde de silicium qui sépare le guide d'onde 28 du guide d'onde 25. A cet effet, la portion distale 246 forme un renflement. Ici, l'épaisseur de la portion distale 246 est égale à l'épaisseur du guide d'onde 15. Le bras 244 ne forme qu'un seul bloc de matière avec le guide d'onde 15.

Lors du fonctionnement du dispositif 236, la résistance 240 chauffe préférentiellement la portion distale 246 puis, par conduction thermique par l'intermédiaire du bras 244, la chaleur est transmise au guide d'onde 15. Le guide d'onde 15 chauffe donc à son tour ce qui fait varier son indice de réfraction. Dans ce mode de réalisation, la résistance 240 est placée en dehors de la zone 245 où circule le signal résonant. En particulier, la résistance 240 n'est pas située, dans la direction verticale, au-dessus et en vis-à-vis du guide d'onde 15. Ainsi, on limite les pertes optiques tout en étant toujours capable de chauffer efficacement ce guide d'onde.. En effet, par comparaison, dans le dispositif 16, la résistance 80 est en vis-à-vis du guide d'onde 15 et se trouve à l'intérieur de la zone 245 ce qui provoque des pertes optiques. Ici, la chaufferette 237 ne chauffe pas directement le guide d'onde 15 mais le chauffe principalement par l'intermédiaire du bras 244 qui ne véhicule aucun signal optique.

La figure 26 représente un filtre 260 susceptible d'être utilisé à la place du filtre 22. Le filtre 260 comporte :

- un guide d'onde 262 en nitrure de silicium formant un anneau résonant,
- deux guides d'onde 264 et 266 en nitrure de silicium situés dans le même plan que le guide d'onde 262 et raccordés optiquement au guide d'onde 262 par des couplages évanescents respectifs.

Typiquement, le taux de couplage évanescent entre le guide d'onde 262 et les guides d'ondes 264, 266 sont les mêmes que ceux décrit dans le cas du filtre 22. Les deux guides d'onde 264, 266 sont raccordés optiquement par l'intermédiaire des coupleurs adiabatiques 268 et 270, respectivement, aux guides d'onde 15 et 25. Dans ce mode de réalisation, le guide d'onde 262 n'est pas directement raccordé optiquement aux guides d'onde 15 et 25, mais raccordé à ces guides d'onde par l'intermédiaire des guides d'onde 264 et 266 en nitrure de silicium.

De nombreux autres modes de réalisation sont possibles. Par exemple, le dispositif d'accord 16 ou 156 peut être omis. A l'inverse, un dispositif d'accord supplémentaire, tel que le dispositif d'accord 156, peut être ajouté dans n'importe quels modes de réalisation précédemment décrits pour déplacer la bande réfléchissante des réflecteurs.

Le dispositif d'accord n'est pas nécessairement une chaufferette. Par exemple, il est aussi possible d'utiliser en tant que dispositif d'accord une jonction P-N réalisée dans l'un des guides d'onde en silicium. L'indice de réfraction du silicium au niveau de cette jonction P-N varie en fonction de la polarisation de cette jonction. Le signal électronique de commande du dispositif d'accord fait alors varier la polarisation de cette jonction P-N. Cette façon de faire varier l'indice de réfraction du silicium est par exemple décrite plus en détail dans l'article suivant : G.T. Reed et al., « Silicon optical modulators », Natures photonics, Vol 4, août 2010.

Les facteurs de réflexion des réflecteurs avant et arrière peuvent aussi être égaux.

Si le filtre 22 de la source laser 180 est remplacé par le filtre 222 alors la largeur $\Delta R$ de la bande réfléchissante des réflecteurs 182 et 184 peut être réduite. Toutefois, de préférence, elle est supérieure à N x $\Delta v_f$ + DT x (d$\lambda_{Cf}$/dT), où N est un nombre entier supérieur ou égal à deux et égal au nombre de longueurs d'onde $\lambda_{Rj}$ sélectionnées par le filtre 222.

D'autres modes de réalisation du guide d'onde 28 et de l'amplificateur 30 sont possibles. Typiquement, le guide d'onde 28 comporte successivement, en s'éloignant du substrat 60 : une sous-couche inférieure dopée, un empilement de puits quantiques en quaternaire et une sous-couche supérieure dopée de signe opposé à la sous-couche inférieure. La sous-couche 70 dopée peut être réalisée dans d'autres matériaux tels qu'en InP dopé N ou P. Dans ce cas, l'empilement de puits quantiques comporte des sous-couches en InGaAsP ou en GaInNAs ou autres. Pour un exemple de réalisation d'un amplificateur large bande stable en température dans lequel la sous-couche 70 est réalisée en InP, le lecteur peut se référer à l'article suivant: K. Morito et al., « GaInNAs / InP Tensile-Strained Bulk Polarization-Insensitive SOA », ECOC2006, IEEE. Lorsque les sous-couches inférieure et supérieure sont en GaAs, l'empilement de puits quantiques peut être réalisé avec des sous-couches en AlGaAs. Les dopages des sous-couches supérieure et inférieure peuvent être inversés.

En variante, le guide d'onde 28 et l'amplificateur 30 sont raccordés optiquement aux guides d'ondes 15 et 25 par un couplage évanescent. Dans ce cas, les coupleurs adiabatiques 26 et 32 sont omis. Un tel raccordement optique entre l'amplificateur et des guides d'onde en silicium est par exemple décrit dans l'article suivant : A. W. Fang et al., « Electrically pumped hybrid AlGaInAs-silicon evanescent laser », Optics Express, Vol. 14, pp. 9203-9210 (2006).

D'autres modes de réalisation du capteur 40 sont également possibles. Par exemple, en variante, le capteur 40 est remplacé par un capteur de la température de fonctionnement de la source laser. En effet, à chaque température de fonctionnement de la source laser, il est possible d'associer un écart entre les longueurs d'onde $\lambda_{Cf}$ et $\lambda_{Rj}$. Dans ce cas, par exemple, le circuit électronique 42 comporte une table pré-enregistrée qui associe à plusieurs températures de fonctionnement de la source laser, les caractéristiques du signal électrique de commande à générer pour maintenir la longueur d'onde $\lambda_{Li}$ au centre de la bande passante 6 du filtre. Par exemple, cette table pré-enregistrée est construite expérimentalement. La température de la source laser peut être mesurée en utilisant un transducteur, comme une jonction P-N. En effet, les caractéristiques électriques d'une jonction P-N varie en fonction de la température.

En variante, la chaufferette 238 est omise. Dans ce cas, le dispositif 236 n'est plus symétrique par rapport au plan 239. Dans une autre variante, le renflement 246 est omis.

D'autres modes de réalisation du filtre sont possibles. Par exemple, l'anneau résonant peut être remplacé par un multiplexeur en longueur d'onde plus connu sous l'acronyme AWG (« Array Waveguide Grating »). Dans ce dernier cas, le filtre est couplé au guide d'onde en silicium par des coupleurs adiabatiques tels que les coupleurs adiabatiques 268 et 270 représentés sur la figure 26 et non plus par un couplage évanescent.

Il est également possible d'utiliser d'autres matériaux que le nitrure de silicium. Par exemple, il est possible aussi d'utiliser, en tant que matériau moins sensible à la température, le nitrure d'aluminium.

Une source laser qui émet à plusieurs longueurs d'onde $\lambda_{Li}$ peut également être réalisée comme décrit, par exemple, en référence aux figures 2 ou 6 de l'article suivant : Katarzyna Lawmiczuk et al. « Design of integrated photonic transmitter for application in fiber-to-the-home systems », Photonics Applications in Astronomy, Communications, Industry and High-Energy Physics Experiments 2010 Proceedings of SPIE, vol 7745, 2010. Dans ce cas, le filtre est un multiplexeur démultiplexeur connu sous l'acronyme de AWG (« Array Waveguide Grating »). C'est alors ce composant AWG qui est réalisé dans le matériau moins sensible à la température.

D'autres procédés de fabrication sont possibles. Par exemple, le procédé décrit en référence à la figure 17 de l'article suivant peut être facilement adapté pour fabriquer une source laser telle que la source laser 150 : Martijn J.R. Heck et al, « Ultra-low loss waveguide plateform and its integration with silicon photonics », Laser photonics rev. 8, n°5, pages 667-686 (2014). Plus précisément, le guide d'onde 50 est fabriqué dans un premier substrat. Ensuite, un second substrat SOI est collé sur le premier substrat. Les guides d'onde 15 et 25 sont alors réalisés dans la couche en silicium de ce second substrat. Enfin, la couche 68 est collée au-dessus du guide d'onde en silicium et l'amplificateur 30 est réalisé dans cette couche 68.

Dans un autre mode de réalisation, la couche intermédiaire 126 est obtenue en retirant la totalité de la couche 106, puis en déposant sur la couche 66 mise à nue une couche d'oxyde de silicium.

Enfin, l'ordre dans lequel sont agencés les différents composants photoniques à l'intérieur de la cavité de Fabry-Pérot peut être modifié. Par exemple, le filtre 22 peut être placé entre le coupleur 32 et le réflecteur 14.

Le dispositif d'accord 236 peut être utilisé dans tout système photonique à semi-conducteur où il est nécessaire de chauffer un guide d'onde optique en limitant les pertes. En particulier, il peut être utilisé pour chauffer un guide d'onde d'un autre système qu'une source laser. Cette autre système peut être un modulateur de phase ou d'intensité d'un signal optique.

## Revendications

1. Source laser à semi-conducteur apte à émettre à au moins une longueur d'onde $\lambda_{Li}$, cette source laser comportant :

   - un réflecteur avant (14 ; 194 ; 222) et un réflecteur arrière (12 ; 182, 184 ; 192 ; 224), ces réflecteurs avant et arrière formant les extrémités d'une cavité optique de Fabry-Pérot apte à faire résonner un signal optique à plusieurs fréquences de résonance possibles, les longueurs d'onde possibles $\lambda_{Rj}$ de ces fréquences de résonance possibles étant régulièrement espacées les unes des autres par un intervalle $\Delta\lambda_R$ et toutes comprises à l'intérieur d'une bande réfléchissante des réflecteurs avant et arrière centrée sur une longueur d'onde $\lambda_{CR}$ et de largeur $\Delta R$,
   - un ensemble de guides d'onde raccordant optiquement les réflecteurs avant et arrière entre eux, cet ensemble comportant :

     • un guide d'onde (15, 25) en silicium,
     • un filtre passe-bande (22 ; 222 ; 260) réalisé dans un guide d'onde (50) et agencé pour être traversé par le signal optique résonant entre les réflecteurs avant et arrière, ce filtre passe-bande étant apte à sélectionner au moins une longueur d'onde $\lambda_{Li}$ parmi les longueurs d'onde $\lambda_{Rj}$, le filtre passe-bande comportant à cet effet une bande passante centrée sur chaque longueur d'onde $\lambda_{Li}$ à sélectionner, chaque bande passante du filtre étant centrée sur une longueur d'onde centrale $\lambda_{Cf}$ respective et ayant une largeur $\Delta\lambda_f$ de bande

inférieure ou égal à l'intervalle $\Delta\lambda_R$,
• un guide d'onde (28) en matériau à gain III-V apte à générer du gain optique à chaque longueur d'onde $\lambda_{Li}$ sélectionnée par le filtre et agencé pour être traversé par le signal optique résonant entre les réflecteurs avant et arrière, ce guide d'onde étant couplé optiquement au guide d'onde en silicium par un couplage adiabatique (26, 32) ou évanescent,

**caractérisé en ce que** :

- le guide d'onde (50 ; 262) dans lequel est réalisé le filtre (22 ; 222 ; 260) est en matériau moins sensible à la température, c'est-à-dire réalisé dans un matériau dont la variation $dn_f/dT$ de son indice de réfraction en fonction de la température est au moins deux fois inférieure à la variation $dn_{Si}/dT$ de l'indice de réfraction du silicium en fonction de la température, et
- la source laser comporte aussi :

• un dispositif d'accord (16 ; 202 ; 236) apte à décaler les longueurs d'onde $\lambda_{Rj}$ en réponse à un signal électrique de commande,
• un capteur (40) apte à mesurer une grandeur physique représentative de l'écart entre la longueur d'onde centrale $\lambda_{Cf}$ et l'une des longueurs d'onde $\lambda_{Rj}$ possible,
• un circuit électronique (42) apte à générer, en fonction de la grandeur physique mesurée par le capteur, le signal électrique de commande du dispositif d'accord pour maintenir une longueur d'onde $\lambda_{Rj}$ au centre de chaque bande passante du filtre qui sélectionne une longueur d'onde $\lambda_{Li}$, et

- la largeur $\Delta R$ de la bande réfléchissante de chaque réflecteur avant et arrière est :

• strictement supérieure à $\Delta\lambda_f + DT \times (d\lambda_{CR}/dT)$ si le filtre est agencé pour sélectionner uniquement une seule longueur d'onde $\lambda_{Li}$, et
• strictement supérieure à $\Delta\lambda_f + \max \{DT \times (d\lambda_{CR}/dT); N \times \Delta v_f + DT \times (d\lambda_{Cf}/dT)\}$ si le filtre est agencé pour sélectionner N longueurs d'onde $\lambda_{Li}$,
où DT est la largeur d'une gamme prédéterminée de températures de fonctionnement pour la source laser, $d\lambda_{CR}/dT$ est la variation de la longueur d'onde centrale $\lambda_{CR}$ des réflecteurs en fonction de la température exprimée en nm/°C, $d\lambda_{Cf}/dT$ est la variation de la longueur d'onde centrale $\lambda_{Cf}$ du filtre en fonction de la température exprimée en nm/°C, N est un nombre entier supérieur ou égal à deux, $\Delta v_f$ est l'intervalle entre deux bandes passantes successives du filtre exprimée en nanomètre et max{...} est la fonction qui retourne le plus grand des éléments situés entre les accolades.

2. Source laser selon la revendication 1 émettant uniquement à une seule longueur d'onde $\lambda_{Li}$, dans laquelle le filtre (22 ; 260) comporte un anneau résonant et les bande-passantes de ce filtre sont régulièrement espacées les unes des autres par un intervalle $\Delta v_f$ supérieur à la largeur $\Delta R$.

3. Source laser selon la revendication 1 émettant simultanément à plusieurs longueurs d'ondes $\lambda_{Li}$, dans laquelle le filtre (222) comporte un anneau résonant et les bandes passantes de ce filtre sont régulièrement espacées les unes des autres par un intervalle $\Delta v_f$ égal à un multiple entier de l'intervalle $\Delta\lambda_R$ et strictement inférieur à la largeur $\Delta R$.

4. Source laser selon l'une quelconque des revendications 2 à 3, dans laquelle la source laser comporte :

- un substrat (60) qui s'étend essentiellement dans un plan appelé « plan du substrat »,
- le guide d'onde (15, 25) en silicium qui s'étend parallèlement au plan du substrat à l'intérieur d'une première couche (66), ce guide d'onde en silicium guidant le signal optique résonant entre les réflecteurs avant et arrière,
- le guide d'onde (50 ; 262) dans lequel est réalisé l'anneau résonant s'étend entièrement dans une deuxième couche (64) disposée au-dessus ou au-dessous de la première couche (66), le guide d'onde (50 ; 262) dans lequel est réalisé l'anneau résonant étant raccordé optiquement au guide d'onde (15, 25) en silicium seulement par couplage évanescent.

5. Source laser selon l'une quelconque des revendications précédentes, dans laquelle la source laser comporte :

- un substrat (60) qui s'étend essentiellement dans un plan appelé « plan du substrat »,
- le guide d'onde (15, 25) en silicium qui s'étend parallèlement au plan du substrat à l'intérieur d'une première couche (66), ce guide d'onde en silicium guidant le signal optique résonant entre les réflecteurs avant et arrière,

- le guide d'onde (50 ; 262) en matériau moins sensible à la température s'étend parallèlement au plan du substrat à l'intérieur d'une deuxième couche (64) située au-dessus ou au-dessous de la première couche et ce guide d'onde en matériau moins sensible à la température étant raccordé optiquement au guide d'onde en silicium par un couplage évanescent ou adiabatique,
- le guide d'onde (28) en matériau à gain III-V s'étend parallèlement au plan du substrat à l'intérieur d'une troisième couche (68) située d'un côté de la première couche opposé au côté où est situé la deuxième couche.

6. Source laser selon selon l'une quelconque des revendications précédentes, dans laquelle la source laser comporte :

- un substrat (60) qui s'étend essentiellement dans un plan appelé « plan du substrat »,
- le guide d'onde (28) en matériau à gain III-V comporte une sous-couche (70) en matériau III-V dopée P ou N qui s'étend dans un plan parallèle au plan du substrat,
- le dispositif d'accord (16) comporte :

    • une résistance (80) réalisée dans le même matériau et avec le même dopage que ladite sous-couche (70) en matériau III-V dopée N ou P, cette résistance s'étendant au-dessus ou au-dessous du guide d'onde (15, 25) en silicium dans le même plan que la sous-couche (70) en matériau III-V dopée P ou N, et
    • des prises (82, 84) de raccordement électrique aptes à faire circuler un courant électrique à l'intérieur de cette résistance pour chauffer le guide d'onde en silicium situé au-dessus ou au-dessous en réponse au signal électrique de commande.

7. Source laser selon l'une quelconque des revendications précédentes, dans laquelle le matériau moins sensible à la température est du nitrure de silicium ou du nitrure d'aluminium.

8. Source laser selon l'une quelconque des revendications précédentes, dans laquelle le dispositif d'accord (236) comporte :

- un bras latéral (244) en silicium qui s'étend, dans une direction latérale perpendiculaire à un axe longitudinal du guide d'onde en silicium, depuis le guide d'onde en silicium jusqu'à une portion distale (246), ce bras latéral ayant une épaisseur, dans une direction verticale perpendiculaire à l'axe longitudinal, inférieure à l'épaisseur du guide d'onde en silicium dans la même direction verticale,
- une résistance (240) située en vis-à-vis de la portion distale (246) et en-dehors de la zone où circule le signal optique résonant guidé par le guide d'onde en silicium, et
- des prises (242) de contact électrique pour faire circuler le signal électrique de commande à travers la résistance.

9. Source laser selon l'une quelconque des revendications précédentes, dans laquelle les réflecteurs (182, 184 ; 192, 194) avant et arrière sont au moins en partie réalisés dans le matériau moins sensible à la température.

10. Source laser selon l'une quelconque des revendications précédentes, dans laquelle les réflecteurs avant et arrière (12, 14 ;182, 184 ; 192, 194) sont des réseaux de Bragg.

11. Source laser selon l'une quelconque des revendications précédentes, dans laquelle la largeur DT de la gamme prédéterminée de températures de fonctionnement pour la source laser est supérieure à 30°C.

12. Procédé de fabrication d'une source laser conforme à l'une quelconque des revendications précédentes, ce procédé comportant :

- la fabrication (110) d'un réflecteur avant et d'un réflecteur arrière, ces réflecteurs avant et arrière formant les extrémités d'une cavité optique de Fabry-Pérot apte à faire résonner un signal optique à plusieurs fréquences de résonance possibles, les longueurs d'onde possibles $\lambda_{Rj}$ de ces fréquences de résonance possibles étant régulièrement espacées les unes des autres par un intervalle $\Delta\lambda_R$ et toutes comprises à l'intérieur d'une bande réfléchissante des réflecteurs avant et arrière centrée sur une longueur d'onde $\lambda_{CR}$ et de largeur $\Delta R$,
- la fabrication (110, 116, 128 ; 152, 158, 160) d'un ensemble de guides d'onde raccordant optiquement les réflecteurs avant et arrière entre eux, cet ensemble comportant :

    • un guide d'onde en silicium,
    • un filtre passe-bande réalisé dans un guide d'onde et agencé pour être traversé par le signal optique résonant entre les réflecteurs avant et arrière, ce filtre passe-bande étant apte à sélectionner au moins une longueur d'onde $\lambda_{Li}$ parmi les longueurs d'onde $\lambda_{Rj}$, le filtre passe-bande comportant à cet effet une bande passante centrée sur chaque longueur d'onde $\lambda_{Li}$ à sélectionner, chaque bande passante du filtre étant centrée sur une longueur d'onde centrale $\lambda_{Cf}$ respective et ayant une largeur $\Delta\lambda_f$ de bande inférieure ou égal à l'intervalle $\Delta\lambda_R$,

• un guide d'onde en matériau à gain III-V apte à générer du gain optique à chaque longueur d'onde $\lambda_{Li}$ sélectionnée par le filtre et agencé pour être traversé par le signal optique résonant entre les réflecteurs avant et arrière, ce guide d'onde étant couplé au guide d'onde en silicium par un couplage adiabatique ou évanescent,

**caractérisé en ce que** :

- la fabrication de l'ensemble de guides d'onde comporte la fabrication (116, 160) du guide d'onde dans lequel est réalisé le filtre en un matériau moins sensible à la température, c'est-à-dire un matériau dont la variation $dn_f/dT$ de son indice de réfraction en fonction de la température est au moins deux fois inférieur à la variation $dn_{Si}/dT$ de l'indice de réfraction du silicium en fonction de la température, et
- le procédé comporte aussi :

• la fabrication (128) d'un dispositif d'accord apte à décaler les longueurs d'onde $\lambda_{Rj}$ en réponse à un signal électrique de commande,
• la fabrication (130) d'un capteur apte à mesurer une grandeur physique représentative de l'écart entre la longueur d'onde centrale $\lambda_{Cf}$ et l'une des longueurs d'onde $\lambda_{Rj}$ possible,
• la fabrication (130) d'un circuit électronique apte à générer, en fonction de la grandeur physique mesurée par le capteur, le signal électrique de commande du dispositif d'accord pour maintenir au moins une longueur d'onde $\lambda_{Rj}$ au centre de chaque bande passante du filtre qui sélectionne une longueur d'onde $\lambda_{Li}$, et

- la fabrication (110) du réflecteur avant et du réflecteur arrière comporte également l'agencement de ces réflecteurs pour que la largeur $\Delta R$ de la bande réfléchissante de chaque réflecteur avant et arrière soit :

• strictement supérieure à $\Delta\lambda_f + DT \times (d\lambda_{CR}/dT)$ si le filtre est agencé pour sélectionner uniquement une seule longueur d'onde $\lambda_{Li}$, et
• strictement supérieure à $\Delta\lambda_f + \max\{DT \times (d\lambda_{CR}/dT); N \times \Delta v_f + DT \times (d\lambda_{Cf}/dT)\}$ si le filtre est agencé pour sélectionner N longueurs d'onde $\lambda_{Li}$,

où DT est la largeur d'une gamme prédéterminée de températures de fonctionnement pour la source laser, $d\lambda_{CR}/dT$ est la variation de la longueur d'onde centrale $\lambda_{CR}$ des réflecteurs en fonction de la température exprimée en nm/°C, $d\lambda_{Cf}/dT$ est la variation de la longueur d'onde centrale $\lambda_{Cf}$ du filtre en fonction de la température exprimée en nm/°C, N est un nombre entier supérieur où égal à deux, $\Delta v_f$ est l'intervalle entre deux bandes passantes successives du filtre exprimée en nanomètre et max{...} est la fonction qui retourne le plus grand des éléments situés entre les accolades.

13. Procédé selon la revendication 12, dans lequel le procédé comporte :

- la fabrication (110) des réflecteurs avant et arrière et des guides d'onde en silicium dans une première couche de silicium en face avant d'un premier substrat SOI (« Silicon on Insulator »), ce premier substrat SOI comportant un premier substrat en silicium séparé de la première couche par une première couche d'oxyde de silicium, puis
- avant la fabrication du guide d'onde en matériau à gain, la fabrication du filtre comporte successivement : le dépôt (116) sur une face avant de la première couche d'une couche réalisée dans le matériau moins sensible à la température, puis la gravure de cette couche déposée pour former le guide d'onde dans lequel est réalisé le filtre, puis l'encapsulation du filtre dans une couche d'oxyde de silicium, et enfin le polissage de cette couche d'oxyde de silicium, puis
- le collage (120) de la face extérieure de la couche d'oxyde de silicium polie sur un second substrat, puis
- le retrait (124) du premier substrat en silicium et d'au moins une partie de la première couche d'oxyde du premier substrat SOI pour obtenir une face de collage située, par rapport à la première couche en silicium, du côté opposé à celui où se trouve le filtre, puis
- le collage ou dépôt (128) d'une couche en matériau III-V à gain sur cette face de collage, puis
- la fabrication (130) du guide d'onde en matériau à gain dans cette couche en matériau III-V à gain collée.

**Patentansprüche**

1.  Laserquelle mit Halbleiter, die in der Lage ist, mindestens eine Wellenlänge $\lambda_{Li}$ auszusenden, wobei diese Laserquelle umfasst:

    - einen vorderen Reflektor (14; 194; 222) und einen hinteren Reflektor (12; 182, 184; 192; 224), wobei dieser vordere und dieser hintere Reflektor die Enden eines optischen Resonators nach Fabry-Pérot bilden, der in der Lage ist, ein optisches Signal mit mehreren möglichen Resonanzfrequenzen mitschwingen zu lassen, wobei die möglichen Wellenlängen $\lambda_{Rj}$ dieser möglichen Resonanzfrequenzen um ein Intervall $\Delta\lambda_R$ gleichmäßig voneinander beabstandet sind und alle innerhalb eines reflektierenden Bands des vorderen und des hinteren Reflektors enthalten sind, das auf eine Wellenlänge $\lambda_{CR}$ zentriert ist und eine Breite $\Delta R$ aufweist,
    - eine Anordnung von Wellenleitern, die den vorderen und den hinteren Reflektor optisch miteinander verbindet, wobei diese Anordnung umfasst:

        • einen Wellenleiter (15, 25) aus Silizium,
        • einen Bandpassfilter (22; 222; 260), der aus einem Wellenleiter (50) gebildet ist und angeordnet ist, von dem optischen Signal durchlaufen zu werden, das zwischen dem vorderen und dem hinteren Reflektor mitschwingt, wobei dieser Bandpassfilter in der Lage ist, mindestens eine Wellenlänge $\lambda_{Li}$ aus den Wellenlängen $\lambda_{Rj}$ auszuwählen, wobei der Bandpassfilter zu diesem Zweck einen Durchlassbereich umfasst, der auf jede auszuwählende Wellenlänge $\lambda_{Li}$ zentriert ist, wobei jeder Durchlassbereich des Filters auf eine jeweilige zentrale Wellenlänge $\lambda_{Cf}$ zentriert ist und eine Bandbreite $\Delta\lambda_f$ aufweist, die kleiner oder gleich dem Intervall $\Delta\lambda_R$ ist,
        • einen Wellenleiter (28) aus Verstärkungsmaterial III-V, der in der Lage ist, auf jeder Wellenlänge $\lambda_{Li}$, die durch den Filter ausgewählt ist, eine optische Verstärkung zu erzeugen, und angeordnet ist, von dem optischen Signal durchlaufen zu werden, das zwischen dem vorderen und dem hinteren Reflektor mitschwingt, wobei dieser Wellenleiter durch eine adiabatische (26, 32) oder evaneszente Kopplung mit dem Wellenleiter aus Silizium optisch gekoppelt ist,

    **dadurch gekennzeichnet, dass**

    - der Wellenleiter (50; 262), aus dem der Filter (22; 222; 260) gebildet ist, aus einem Material ist, das weniger temperaturempfindlich ist, d. h. aus einem Material gebildet ist, dessen Abweichung $dn_f/dT$ von seinem Brechungsindex in Abhängigkeit von der Temperatur mindestens zweimal kleiner als die Abweichung $dn_{Si}/dT$ vom Brechungsindex des Siliziums in Abhängigkeit von der Temperatur ist, und
    - die Laserquelle auch Folgendes umfasst:

        • eine Abstimmungsvorrichtung (16; 202; 236), die in der Lage ist, die Wellenlängen $\lambda_{Rj}$ in Reaktion auf ein elektrisches Steuersignal zu verschieben,
        • einen Sensor (40), der in der Lage ist, eine physikalische Größe zu messen, die den Abstand zwischen der zentralen Wellenlänge $\lambda_{Cf}$ und einer der möglichen Wellenlängen $\lambda_{Rj}$ darstellt,
        • eine elektronische Schaltung (42), die in der Lage ist, in Abhängigkeit von der physikalischen Größe, die von dem Sensor gemessen wurde, das elektrische Steuersignal der Abstimmungsvorrichtung zu erzeugen, um eine Wellenlänge $\lambda_{Rj}$ im Zentrum jedes Durchlassbereichs des Filters zu halten, der eine Wellenlänge $\lambda_{Li}$ auswählt, und

    - die Breite $\Delta R$ des reflektierenden Bands jedes vorderen und hinteren Reflektors:

        • streng größer als $\Delta\lambda_f + DT \times (d\lambda_{CR}/dT)$ ist, wenn der Filter angeordnet ist, nur eine einzige Wellenlänge $\lambda_{Li}$ auszuwählen, und
        • streng größer als $\Delta\lambda_f + \max\{DT \times (d\lambda_{CR}/dT) ; N \times \Delta v_f + DT \times (d\lambda_{Cf}/dT)\}$ ist, wenn der Filter angeordnet ist, N Wellenlängen $\lambda_{Li}$ auszuwählen, wobei DT die Breite eines vorbestimmten Bereichs von Betriebstemperaturen für die Laserquelle ist, $d\lambda_{CR}/dT$ die Abweichung der zentralen Wellenlänge $\lambda_{CR}$ der Reflektoren in Abhängigkeit von der Temperatur ist, die in nm/°C ausgedrückt wird, $d\lambda_{Cf}/dT$ die Abweichung der zentralen Wellenlänge $\lambda_{Cf}$ des Filters in Abhängigkeit von der Temperatur ist, die in nm/°C ausgedrückt wird, N eine ganze Zahl größer oder gleich zwei ist, $\Delta v_f$ das Intervall zwischen zwei aufeinanderfolgenden Durchlassbereichen des Filters ist, das in Nanometer ausgedrückt wird und $\max\{...\}$ die Funktion ist, die das größte der Elemente zurückgibt, die sich zwischen den geschweiften Klammern befinden.

2. Laserquelle nach Anspruch 1, die nur auf einer Wellenlänge $\lambda_{Li}$ aussendet, wobei der Filter (22; 260) einen Resonanzring umfasst und die Durchlassbereiche dieses Filters in einem Intervall $\Delta v_f$, das größer als die Breite $\Delta R$ ist, gleichmäßig voneinander beabstandet sind.

3. Laserquelle nach Anspruch 1, die gleichzeitig auf mehreren Wellenlängen $\lambda_{Li}$ aussendet, wobei der Filter (222) einen Resonanzring umfasst und die Durchlassbereiche dieses Filters in einem Intervall $\Delta v_f$, das gleich einem ganzzahligen Vielfachen des Intervalls $\Delta \lambda_R$ und streng geringer als die Breite $\Delta R$ ist, gleichmäßig voneinander beabstandet sind.

4. Laserquelle nach einem der Ansprüche 2 bis 3, wobei die Laserquelle Folgendes umfasst:

   - ein Substrat (60), das sich im Wesentlichen in einer Ebene erstreckt, die "Ebene des Substrats" genannt wird,
   - den Wellenleiter (15, 25) aus Silizium, der sich parallel zur Ebene des Substrats innerhalb einer ersten Schicht (66) erstreckt, wobei dieser Wellenleiter aus Silizium das optische Signal leitet, das zwischen dem vorderen und dem hinteren Reflektor mitschwingt,
   - der Wellenleiter (50; 262), aus dem der Resonanzring gebildet ist, sich vollständig in einer zweiten Schicht (64) erstreckt, die über oder unter der ersten Schicht (66) angeordnet ist, wobei der Wellenleiter (50; 262), aus dem der Resonanzring gebildet ist, nur durch evaneszente Kopplung mit dem Wellenleiter (15, 25) aus Silizium optisch gekoppelt ist.

5. Laserquelle nach einem der vorhergehenden Ansprüche, wobei die Laserquelle Folgendes umfasst:

   - ein Substrat (60), das sich im Wesentlichen in einer Ebene erstreckt, die "Ebene des Substrats" genannt wird,
   - den Wellenleiter (15, 25) aus Silizium, der sich parallel zur Ebene des Substrats innerhalb einer ersten Schicht (66) erstreckt, wobei dieser Wellenleiter aus Silizium das optische Signal leitet, das zwischen dem vorderen und dem hinteren Reflektor mitschwingt,
   - der Wellenleiter (50; 262) aus einem Material, das weniger temperaturempfindlich ist, sich parallel zur Ebene des Substrats innerhalb einer zweiten Schicht (64) erstreckt, die sich über oder unter der ersten Schicht befindet, und wobei dieser Wellenleiter aus einem Material, das weniger temperaturempfindlich ist, durch evaneszente oder adiabatische Kopplung mit dem Wellenleiter aus Silizium optisch gekoppelt ist,
   - der Wellenleiter (28) aus Verstärkungsmaterial III-V sich parallel zur Ebene des Substrats innerhalb einer dritten Schicht (68) erstreckt, die sich auf einer Seite der ersten Schicht befindet, die der Seite, auf der sich die zweite Schicht befindet, gegenüberliegt.

6. Laserquelle nach einem der vorhergehenden Ansprüche, wobei die Laserquelle Folgendes umfasst:

   - ein Substrat (60), das sich im Wesentlichen in einer Ebene erstreckt, die "Ebene des Substrats" genannt wird,
   - der Wellenleiter (28) aus Verstärkungsmaterial III-V eine Unterschicht (70) aus Material III-V umfasst, die P- oder N-dotiert ist, die sich in einer Ebene erstreckt, die parallel zur Ebene des Substrats verläuft,
   - die Abstimmungsvorrichtung (16) Folgendes umfasst:

     • einen Widerstand (80), der aus demselben Material und mit derselben Dotierung wie die Unterschicht (70) aus Material III-V, die N- oder P-dotiert ist, gebildet ist, wobei sich dieser Widerstand über oder unter dem Wellenleiter (15, 25) aus Silizium in derselben Ebene wie die Unterschicht (70) aus Material III-V, die P- oder N-dotiert ist, erstreckt, und
     • elektrische Anschlussdosen (82, 84), die in der Lage sind, einen elektrischen Strom innerhalb dieses Widerstands zirkulieren zu lassen, um den Wellenleiter aus Silizium, der sich oberhalb oder unterhalb befindet, in Reaktion auf ein elektrisches Steuersignal zu erhitzen.

7. Laserquelle nach einem der vorhergehenden Ansprüche, wobei das Material, das weniger temperaturempfindlich ist, Siliziumnitrid oder Aluminiumnitrid ist.

8. Laserquelle nach einem der vorhergehenden Ansprüche, wobei die Abstimmungsvorrichtung (236) Folgendes umfasst:

   - einen Seitenarm (244) aus Silizium, der sich von dem Wellenleiter aus Silizium in einer seitlichen Richtung senkrecht zur Längsachse des Wellenleiters aus Silizium bis zu einem distalen Abschnitt (246) erstreckt, wobei dieser Seitenarm in einer vertikalen Richtung senkrecht zur Längsachse eine Dicke aufweist, die geringer als die Dicke des Wellenleiters aus Silizium in derselben vertikalen Richtung ist,
- einen Widerstand (240), der sich gegenüber dem distalen Abschnitt (246) und außerhalb des Bereichs, in dem das mitschwingende optische Signal zirkuliert, das von dem Wellenleiter aus Silizium geleitet wird, befindet, und
- elektrische Kontaktdosen (242), um das elektrische Steuersignal durch den Widerstand zirkulieren zu lassen.

9. Laserquelle nach einem der vorhergehenden Ansprüche, wobei der vordere und der hintere Reflektor (182, 184; 192, 194) zumindest teilweise aus dem Material gebildet sind, das weniger temperaturempfindlich ist.

10. Laserquelle nach einem der vorhergehenden Ansprüche, wobei der vordere und der hintere Reflektor (12, 14; 182, 184; 192, 194) Bragg-Gitter sind.

11. Laserquelle nach einem der vorhergehenden Ansprüche, wobei die Breite DT des vorbestimmten Bereichs von Betriebstemperaturen für die Laserquelle größer als 30 °C ist.

12. Verfahren zur Herstellung einer Laserquelle nach einem der vorhergehenden Ansprüche, wobei dieses Verfahren umfasst:

- das Herstellen (110) eines vorderen Reflektors und eines hinteren Reflektors, wobei dieser vordere und dieser hintere Reflektor die Enden eines optischen Resonators nach Fabry-Pérot bilden, der in der Lage ist, ein optisches Signal mit mehreren möglichen Resonanzfrequenzen mitschwingen zu lassen, wobei die möglichen Wellenlängen $\lambda_{Rj}$ dieser möglichen Resonanzfrequenzen um ein Intervall $\Delta\lambda_R$ gleichmäßig voneinander beabstandet sind und alle innerhalb eines reflektierenden Bands des vorderen und des hinteren Reflektors enthalten sind, das auf eine Wellenlänge $\lambda_{CR}$ zentriert ist und eine Breite $\Delta R$ aufweist,
- das Herstellen (110, 116, 128; 152, 158, 160) einer Anordnung von Wellenleitern, die den vorderen und den hinteren Reflektor optisch miteinander verbindet, wobei diese Anordnung umfasst:

• einen Wellenleiter aus Silizium,
• einen Bandpassfilter, der aus einem Wellenleiter gebildet ist und angeordnet ist, von dem optischen Signal durchlaufen zu werden, das zwischen dem vorderen und dem hinteren Reflektor mitschwingt, wobei dieser Bandpassfilter in der Lage ist, mindestens eine Wellenlänge $\lambda_{Li}$ aus den Wellenlängen $\lambda_{Rj}$ auszuwählen, wobei der Bandpassfilter zu diesem Zweck einen Durchlassbereich umfasst, der auf jede auszuwählende Wellenlänge $\lambda_{Li}$ zentriert ist, wobei jeder Durchlassbereich des Filters auf eine jeweilige zentrale Wellenlänge $\lambda_{Cf}$ zentriert ist und eine Bandbreite $\Delta\lambda_f$ aufweist, die kleiner oder gleich dem Intervall $\Delta\lambda_R$ ist,
• einen Wellenleiter aus Verstärkungsmaterial III-V, der in der Lage ist, auf jeder Wellenlänge $\lambda_{Li}$, die durch den Filter ausgewählt ist, eine optische Verstärkung zu erzeugen, und angeordnet ist, von dem optischen Signal durchlaufen zu werden, das zwischen dem vorderen und dem hinteren Reflektor mitschwingt, wobei dieser Wellenleiter durch eine adiabatische oder evaneszente Kopplung mit dem Wellenleiter aus Silizium gekoppelt ist,

dadurch gekennzeichnet, dass

- das Herstellen der Anordnung von Wellenleitern das Herstellen (116, 160) des Wellenleiters, aus dem der Filter gebildet ist, aus einem Material, das weniger temperaturempfindlich ist, d. h. aus einem Material, dessen Abweichung $dn_f/dT$ von seinem Brechungsindex in Abhängigkeit von der Temperatur mindestens zweimal kleiner als die Abweichung $dn_{Si}/dT$ vom Brechungsindex des Siliziums in Abhängigkeit von der Temperatur ist, umfasst, und
- das Verfahren außerdem Folgendes umfasst:

• das Herstellen (128) einer Abstimmungsvorrichtung, die in der Lage ist, die Wellenlängen $\lambda_{Rj}$ in Reaktion auf ein elektrisches Steuersignal zu verschieben,
• das Herstellen (130) eines Sensors, der in der Lage ist, eine physikalische Größe zu messen, die den Abstand zwischen der zentralen Wellenlänge $\lambda_{Cf}$ und einer der möglichen Wellenlängen $\lambda_{Rj}$ darstellt,
• das Herstellen (130) einer elektronischen Schaltung, die in der Lage ist, in Abhängigkeit von der physikalischen Größe, die von dem Sensor gemessen wurde, das elektrische Steuersignal der Abstimmungsvorrichtung zu erzeugen, um mindestens eine Wellenlänge $\lambda_{Rj}$ im Zentrum jedes Durchlassbereichs des Filters zu halten, der eine Wellenlänge $\lambda_{Li}$ auswählt, und

- das Herstellen (110) des vorderen Reflektors und des hinteren Reflektors ebenfalls das Anordnen dieser Reflektoren umfasst, damit die Breite $\Delta R$ des reflektierenden Bands jedes vorderen und hinteren Reflektors:

  • streng größer als $\Delta\lambda_f + DT \times (d\lambda_{CR}/dT)$ ist, wenn der Filter angeordnet ist, nur eine einzige Wellenlänge $\lambda_{Li}$ auszuwählen, und
  • streng größer als $\Delta\lambda_f + \max \{DT \times (d\lambda_{CR}/dT) ; N \times \Delta v_f + DT \times (d\lambda_{Cf}/dT)\}$ ist, wenn der Filter angeordnet ist, N Wellenlängen $\lambda_{Li}$ auszuwählen,

wobei DT die Breite eines vorbestimmten Bereichs von Betriebstemperaturen für die Laserquelle ist, $d\lambda_{CR}/dT$ die Abweichung der zentralen Wellenlänge $\lambda_{CR}$ der Reflektoren in Abhängigkeit von der Temperatur ist, die in nm/°C ausgedrückt wird, $d\lambda_{Cf}/dT$ die Abweichung der zentralen Wellenlänge $\lambda_{Cf}$ des Filters in Abhängigkeit von der Temperatur ist, die in nm/°C ausgedrückt wird, N eine ganze Zahl größer oder gleich zwei ist, $\Delta v_f$ das Intervall zwischen zwei aufeinanderfolgenden Durchlassbereichen des Filters ist, das in Nanometer ausgedrückt wird und max{...} die Funktion ist, die das größte der Elemente zurückgibt, die sich zwischen den geschweiften Klammern befinden.

13. Verfahren nach Anspruch 12, wobei das Verfahren Folgendes umfasst:

   - das Herstellen (110) des vorderen und des hinteren Reflektors und der Wellenleiter aus Silizium in einer ersten Siliziumschicht auf der Vorderseite eines ersten SOI ("Silicon-on-Insulator")-Substrats, wobei dieses erste SOI-Substrat ein erstes Substrat aus Silizium, das durch eine erste Siliziumoxidschicht von der ersten Schicht getrennt ist, umfasst, dann
   - umfasst das Herstellen des Filters, vor dem Herstellen des Wellenleiters aus Verstärkungsmaterial nacheinander: das Abscheiden (116), auf einer Vorderseite der ersten Schicht, einer Schicht, die aus dem Material gebildet ist, das weniger temperaturempfindlich ist, dann das Ätzen dieser abgeschiedenen Schicht, um den Wellenleiter zu bilden, aus dem der Filter gebildet ist, dann das Einschließen des Filters in einer Siliziumoxidschicht, und schließlich das Polieren dieser Siliziumoxidschicht, dann
   - das Kleben (120) der Außenseite der polierten Siliziumoxidschicht auf ein zweites Substrat, dann
   - das Abziehen (124) des ersten Substrats aus Silizium und mindestens eines Teils der ersten Oxidschicht des ersten SOI-Substrats, um eine Klebefläche zu erhalten, die sich, bezogen auf die erste Siliziumschicht, auf der Seite befindet, die derjenigen, auf sich der Filter befindet, gegenüberliegt, dann
   - das Kleben oder Abscheiden (128) einer Schicht aus Verstärkungsmaterial III-V auf dieser Klebefläche, dann
   - das Herstellen (130) des Wellenleiters aus Verstärkungsmaterial in dieser geklebten Schicht aus Verstärkungsmaterial III-V.

**Claims**

1. Semiconductor laser source able to emit at at least one wavelength $\lambda_{Li}$, this laser source including:

   - a front reflector (14; 194; 222) and a back reflector (12; 182, 184; 192; 224), these front and back reflectors forming the ends of a Fabry-Perot optical cavity able to make resonate an optical signal at a plurality of possible resonant frequencies, the possible wavelengths $\lambda_{Rj}$ of these possible resonant frequencies being regularly spaced apart from one another by an interval $\Delta\lambda_R$ and all comprised inside a reflection band of the front and back reflectors, which band is centred on a wavelength $\lambda_{CR}$ and of width $\Delta R$,
   - a set of waveguides optically connecting the front and back reflectors together, this set including:

     • a waveguide (15, 25) made of silicon,
     • a passband filter (22; 222; 260) produced in a waveguide (50) and arranged to be passed through by the optical signal resonating between the front and back reflectors, this passband filter being able to select at least one wavelength $\lambda_{Li}$ from the wavelengths $\lambda_{Rj}$, the passband filter including for this purpose a passband centred on each wavelength $\lambda_{Li}$ to be selected, each passband of the filter being centred on a respective central wavelength $\lambda_{Cf}$ and having a bandwidth $\Delta\lambda_f$ smaller than or equal to the interval $\Delta\lambda_R$,
     • a waveguide (28) made of III-V gain material able to generate optical gain at each wavelength $\lambda_{Li}$ selected by the filter and arranged to be passed through by the optical signal resonating between the front and back reflectors, this waveguide being optically coupled to the waveguide made of silicon by adiabatic or evanescent coupling (26, 32),

   **characterized in that**:

- the waveguide (50; 262) in which the filter (22; 222; 260) is produced is made of material that is less sensitive to temperature, i.e. produced from a material the variation $dn_f/dT$ in the refractive index as a function of temperature of which is at least two times lower than the variation $dn_{Si}/dT$ in the refractive index of silicon as a function of temperature, and

- the laser source also includes:

  • a tuning device (16; 202; 236) able to shift the wavelengths $\lambda_{Rj}$ in response to an electrical controlling signal,
  • a sensor (40) able to measure a physical quantity representative of the difference between the central wavelength $\lambda_{Cf}$ and one of the possible wavelengths $\lambda_{Rj}$,
  • an electronic circuit (42) able to generate, depending on the physical quantity measured by the sensor, the electrical signal controlling the tuning device in order to keep one wavelength $\lambda_{Rj}$ at the centre of each passband of the filter that selects a wavelength $\lambda_{Li}$, and

- the width $\Delta R$ of the reflection band of each front and back reflector is:

  • strictly larger than $\Delta\lambda_f + DT \times (d\lambda_{CR}/dT)$ if the filter is arranged to solely select a single wavelength $\lambda_{Li}$, and
  • strictly larger than $\Delta\lambda_f + \max\{DT \times (d\lambda_{CR}/dT); N \times \Delta v_f + DT \times (d\lambda_{Cf}/dT)\}$ if the filter is arranged to select N wavelengths $\lambda_{Li}$,
  where DT is the width of a preset range of operating temperatures of the laser source, $d\lambda_{CR}/dT$ is the variation in the central wavelength $\lambda_{CR}$ of the reflectors as a function of temperature expressed in nm/°C, $d\lambda_{Cf}/dT$ is the variation in the central wavelength $\lambda_{Cf}$ of the filter as a function of temperature expressed in nm/°C, N is an integer higher than or equal to two, $\Delta v_f$ is the interval between two successive passbands of the filter expressed in nanometres and max{...} is the function that returns the highest of the elements located between the braces.

2. Laser source according to Claim 1 emitting solely at a single wavelength $\lambda_{Li}$, wherein the filter (22; 260) includes a ring resonator and the passbands of this filter are regularly spaced apart from one another by an interval $\Delta v_f$ wider than the width $\Delta R$.

3. Laser source according to Claim 1 emitting simultaneously at a plurality of wavelengths $\lambda_{Li}$, wherein the filter (222) includes a ring resonator and the passbands of this filter are regularly spaced apart from one another by an interval $\Delta v_f$ equal to an integer multiple of the interval $\Delta\lambda_R$ and strictly smaller than the width $\Delta R$.

4. Laser source according to either one of Claims 2 and 3, wherein the laser source includes:

   - a substrate (60) that essentially extends in a plane called the "plane of the substrate", and
   - the waveguide (15, 25) made of silicon, which extends parallelly to the plane of the substrate inside a first layer (66), this waveguide made of silicon guiding the optical signal resonating between the front and back reflectors, and
   - the waveguide (50; 262) in which the ring resonator is produced extends entirely in a second layer (64) that is placed above or below the first layer (66), the waveguide (50; 262) in which the ring resonator is produced being optically connected to the waveguide (15, 25) made of silicon solely by evanescent coupling.

5. Laser source according to any one of the preceding claims, wherein the laser source includes:

   - a substrate (60) that essentially extends in a plane called the "plane of the substrate", and
   - the waveguide (15, 25) made of silicon, which extends parallelly to the plane of the substrate inside a first layer (66), this waveguide made of silicon guiding the optical signal resonating between the front and back reflectors, and
   - the waveguide (50; 262) made of material that is less sensitive to temperature extends parallelly to the plane of the substrate inside a second layer (64) that is placed above or below the first layer and this waveguide made of material that is less sensitive to temperature being optically connected to the waveguide made of silicon by evanescent or adiabatic coupling, and
   - the waveguide (28) made of III-V gain material extends parallelly to the plane of the substrate inside a third layer (68) that is located on that side of the first layer which is opposite the side on which the second layer is located.

6. Laser source according to any one of the preceding claims, wherein the laser source includes:

- a substrate (60) that essentially extends in a plane called the "plane of the substrate", and
- the waveguide (28) made of III-V gain material includes a sublayer (70) made of nor p-doped III-V material that extends in a plane parallel to the plane of the substrate, and
- the tuning device (16) includes:

• a resistor (80) produced from the same material and with the same doping as said sublayer (70) made of p- or n-doped III-V material, this resistor extending above or below the waveguide (15, 25) made of silicon in the same plane as the sublayer (70) made of n- or p-doped III-V material, and
• electrical contacts (82, 84) usable to make an electrical current flow inside this resistor in order to heat the waveguide made of silicon located above or below in response to the electrical controlling signal.

7. Laser source according to any one of the preceding claims, wherein the material that is less sensitive to temperature is silicon nitride or aluminium nitride.

8. Laser source according to any one of the preceding claims, wherein the tuning device (236) includes:

- a lateral arm (244) made of silicon that extends, in a lateral direction perpendicular to a longitudinal axis of the waveguide made of silicon, from the waveguide made of silicon as far as a distal section (246), this lateral arm having a thickness, in a vertical direction perpendicular to the longitudinal axis, smaller than the thickness of the waveguide made of silicon in the same vertical direction,
- a resistor (240) located facing the distal section (246) and outside of the zone through which the resonant optical signal guided by the waveguide made of silicon circulates, and
- electrical contacts (242) usable to make the electrical controlling signal flow through the resistor.

9. Laser source according to any one of the preceding claims, wherein the front and back reflectors (182, 184; 192, 194) are at least partially produced from the material that is less sensitive to temperature.

10. Laser source according to any one of the preceding claims, wherein the front and back reflectors (12, 14; 182, 184; 192, 194) are Bragg gratings.

11. Laser source according to any one of the preceding claims, wherein the width DT of the preset range of operating temperatures of the laser source is larger than 30°C.

12. Process for manufacturing a laser source according to any one of the preceding claims, this process including:

- manufacturing (110) a front reflector and a back reflector, these front and back reflectors forming the ends of a Fabry-Perot optical cavity able to make resonate an optical signal at a plurality of possible resonant frequencies, the possible wavelengths $\lambda_{Rj}$ of these possible resonant frequencies being regularly spaced apart from one another by an interval $\Delta\lambda_R$ and all comprised inside a reflection band of the front and back reflectors, which band is centred on a wavelength $\lambda_{CR}$ and of width $\Delta R$,
- manufacturing (110, 116, 128; 152, 158, 160) a set of waveguides optically connecting the front and back reflectors together, this set including:

• a waveguide made of silicon,
• a passband filter produced in a waveguide and arranged to be passed through by the optical signal resonating between the front and back reflectors, this passband filter being able to select at least one wavelength $\lambda_{Li}$ from the wavelengths $\lambda_{Rj}$ the passband filter including for this purpose a passband centred on each wavelength $\lambda_{Li}$ to be selected, each passband of the filter being centred on a respective central wavelength $\lambda_{Cf}$ and having a bandwidth $\Delta\lambda_f$ smaller than or equal to the interval $\Delta\lambda_R$,
• a waveguide made of III-V gain material able to generate optical gain at each wavelength $\lambda_{Li}$ selected by the filter and arranged to be passed through by the optical signal resonating between the front and back reflectors, this waveguide being coupled to the waveguide made of silicon by adiabatic or evanescent coupling,

**characterized in that**:

- the manufacture of the set of waveguides includes manufacturing (116, 160) the waveguide in which the filter is produced from a material that is less sensitive to temperature, i.e. a material the variation $dn_f/dT$ in the refractive index as a function of temperature of which is at least two times lower than the variation $dn_{Si}/dT$ in the refractive index of silicon as a function of temperature, and
- the process also includes:

  • manufacturing (128) a tuning device able to shift the wavelengths $\lambda_{Rj}$ in response to an electrical controlling signal,
  • manufacturing (130) a sensor able to measure a physical quantity representative of the difference between the central wavelength $\lambda_{Cf}$ and one of the possible wavelengths $\lambda_{Rj}$,
  • manufacturing (130) an electronic circuit able to generate, depending on the physical quantity measured by the sensor, the electrical signal controlling the tuning device in order to keep one wavelength $\lambda_{Rj}$ at the centre of each passband of the filter that selects a wavelength $\lambda_{Li}$, and

- the manufacture (110) of the front reflector and of the back reflector also includes arranging these reflectors so that the width $\Delta R$ of the reflection band of each front and back reflector is:

  • strictly wider than $\Delta\lambda_f + DT \times (d\lambda_{CR}/dT)$ if the filter is arranged to solely select a single wavelength $\lambda_{Li}$, and
  • strictly wider than $\Delta\lambda_f + \max\{DT \times (d\lambda_{CR}/dT); N \times \Delta v_f + DT \times (d\lambda_{Cf}/dT)\}$ if the filter is arranged to select N wavelengths $\lambda_{Li}$,

where DT is the width of a preset range of operating temperatures of the laser source, $d\lambda_{CR}/dT$ is the variation in the central wavelength $\lambda_{CR}$ of the reflectors as a function of temperature expressed in nm/°C, $d\lambda_{Cf}/dT$ is the variation in the central wavelength $\lambda_{Cf}$ of the filter as a function of temperature expressed in nm/°C, N is an integer higher than or equal to two, $\Delta v_f$ is the interval between two successive passbands of the filter expressed in nanometres and $\max\{...\}$ is the function that returns the highest of the elements located between the braces.

**13.** Process according to Claim 12, wherein the process includes:

- manufacturing (110) the front and back reflectors and the waveguides made of silicon in a front-side silicon first layer of a first silicon-on-insulator (SOI) substrate, this first SOI substrate including a first silicon substrate separated from the first layer by a first silicon-oxide layer, then
- before the first waveguide made of gain material is manufactured, manufacturing the filter, the manufacture of the filter including, in succession: depositing (116), on a front side of the first layer, a layer produced from the material that is less sensitive to temperature, then etching this deposited layer to form the waveguide in which the filter is produced, then encapsulating the filter in a silicon-oxide layer, and lastly polishing this silicon-oxide layer, then
- bonding (120) the exterior face of the polished silicon-oxide layer on a second substrate, then
- removing (124) the first silicon substrate and at least some of the first oxide layer of the first SOI substrate to obtain a bonding face located, with respect to the first silicon layer, on the opposite side to that on which the filter is found, then
- bonding or depositing (128) a layer made of III-V gain material on this bonding face, then
- manufacturing (130) the waveguide made of gain material in this bonded layer made of III-V gain material.

Fig. 1

Fig. 2

Fig. 3

Fig. 4

Fig. 5

Fig. 6

EP 3 190 672 B1

Fig. 7

Fig. 8

| 100 |
| 110 |
| 112 |
| 116 |
| 120 |
| 124 |
| 128 |
| 130 |
| 132 |

Fig. 9

| 100 |
| 110 |
| 112 |
| 152 |
| 158 |
| 160 |
| 162 |

Fig. 15

Fig. 10

Fig. 11

Fig. 12

Fig. 13

Fig. 14

Fig. 16

Fig. 17

Fig. 18

Fig. 19

Fig. 20

Fig. 21

Fig. 22

Fig. 23

Fig. 24

Fig. 25

Fig. 26

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015180201 A1
- US 2014153600 A1
- US 2014153601 A1
- GB 2522252 A
- US 2009135891 A1

**Littérature non-brevet citée dans la description**

- Compact and Low Power Consumption Hybrid Integrated Wavelength Tunable Laser Module Using Silicon Waveguide Resonators. **NOBUHIDE FUJIOKA et al.** Journal of Lightwave Technology. IEEE Service center, 01 Novembre 2010, vol. 28
- **AMNON YARIV et al.** Supermode Si/III-V hybrid Lasers, optical amplifiers and modulators: proposai and analysis. *Optics Express 9147,* 23 Juillet 2007, vol. 14 (15
- **DIMITRIS FITSIOS et al.** High-gain 1,3 $\mu$m GaInNAs semiconductor optical amplifier with enchanced temperature stability for all-optical processing at 10 Gb/s. *Applied optics,* 01 Janvier 2015, vol. 54 (1
- **G.T. REED et al.** Silicon optical modulators. *Natures photonics,* Août 2010, vol. 4
- GainNAs / InP Tensile-Strained Bulk Polarization-Insensitive SOA. **K. MORITO et al.** ECOC2006. IEEE
- **A. W. FANG et al.** Electrically pumped hybrid AlGaIn-As-silicon evanescent laser. *Optics Express,* 2006, vol. 14, 9203-9210
- **KATARZYNA LAWMICZUK et al.** Design of integrated photonic transmitter for application in fiber-to-the-home systems. *Photonics Applications in Astronomy, Communications, Industry and High-Energy Physics Experiments 2010 Proceedings of SPIE,* 2010, vol. 7745
- **MARTIJN J.R. HECK et al.** Ultra-low loss waveguide plateform and its integration with silicon photonics. *Laser photonics rev.,* 2014, vol. 8 (5), 667-686